(19) **Europäisches Patentamt / European Patent Office / Office européen des brevets**

(11) **EP 2 479 227 B1**

(12) **EUROPEAN PATENT SPECIFICATION**

(45) Date of publication and mention
of the grant of the patent:
**07.01.2015 Bulletin 2015/02**

(51) Int Cl.:
***C09D 11/00*** *(2014.01)*    ***H05K 1/09*** *(2006.01)*

(21) Application number: **10817132.3**

(22) Date of filing: **13.09.2010**

(86) International application number:
**PCT/JP2010/065715**

(87) International publication number:
**WO 2011/034019 (24.03.2011 Gazette 2011/12)**

(54) **Process for making printing ink**

Verfahren zur Herstellung von Drucktinte

Procédé pour la fabrication d'encre d'impression

(84) Designated Contracting States:
**AL AT BE BG CH CY CZ DE DK EE ES FI FR GB GR HR HU IE IS IT LI LT LU LV MC MK MT NL NO PL PT RO SE SI SK SM TR**

(30) Priority: **16.09.2009 JP 2009215001**
**29.01.2010 JP 2010018417**
**08.02.2010 JP 2010025318**

(43) Date of publication of application:
**25.07.2012 Bulletin 2012/30**

(73) Proprietor: **Hitachi Chemical Company, Ltd.**
**Chiyoda-ku**
**Tokyo 100-6606 (JP)**

(72) Inventors:
• **NAKAKO, Hideo**
**Tsukuba-shi**
**Ibaraki 300-4247 (JP)**
• **YAMAMOTO, Kazunori**
**Tsukuba-shi**
**Ibaraki 300-4247 (JP)**
• **KUMASHIRO, Yasushi**
**Tsukuba-shi**
**Ibaraki 300-4247 (JP)**

• **YOKOSAWA, Shunya**
**Tokyo 163-0449 (JP)**
• **EJIRI, Yoshinori**
**Chikusei-shi**
**Ibaraki 308-8521 (JP)**
• **MASUDA, Katsuyuki**
**Chikusei-shi**
**Ibaraki 308-8521 (JP)**
• **KURODA, Kyoko**
**Tsukuba-shi**
**Ibaraki 300-4247 (JP)**
• **INADA, Maki**
**Tsukuba-shi**
**Ibaraki 300-4247 (JP)**

(74) Representative: **Adam, Holger**
**Kraus & Weisert**
**Patentanwälte PartGmbB**
**Thomas-Wimmer-Ring 15**
**80539 München (DE)**

(56) References cited:
**WO-A1-2009/054343    WO-A1-2009/078448**

EP 2 479 227 B1

**Description**

TECHNICAL FIELD

The present invention relates to a producing process for an ink for printing processes, which ink includes metal nanoparticles containing Cu and/or CuO and/or $Cu_2O$. The ink for printing processes can be used for the formation of conductor layers and wiring patterns. A wiring, a circuit board and a semiconductor package can be formed by using the ink for printing processes.

BACKGROUND ART

Attention is being paid to techniques of printing and forming various functional inks by a printing process that is represented by inkjet printing or the like. Among them, investigations are being conducted on the ink in which particles containing Cu and/or Cu oxides are dispersed, from the viewpoint of forming printed conductor wiring. In the process of printing by inkjetting, since a system of scattering fine liquid droplets through fine nozzles is employed, when coarse particles having a size close to the ink nozzle size are included in the ink, clogging of nozzles occur. Furthermore, when viscosity increases as a result of addition of particles, the ink cannot be scattered as liquid droplets. Even in other printing processes, coarse particles are inappropriate for the printing of fine lines.

Specifically, there has been disclosed a method of forming a metal thin film using a dispersion liquid which has dispersed therein copper fine particles having a particle size of 100 nm or less that are produced according to a gas-mediated metal evaporation method of evaporating a metal in a low vacuum gas atmosphere and in a gas phase where the vapor of a solvent is co-present, and thereby obtaining a dispersion liquid (see, for example, Patent Document 1). However, metal ultrafine particles obtainable by such a gas-mediated metal evaporation method are in an aggregated state, so that even if dispersion of the ultrafine particles in the solvent is attempted, it is difficult to bring the particles to a stable state. Therefore, even when such a dispersion liquid of metal ultrafine particles is used as an inkjet ink, there is a problem that aggregates of the metal ultrafine particles cause clogging of inkjet nozzles.

In the particle-containing inks for printing such as described above, it is necessary to use particles having a small particle size and to disperse the particles without aggregation. The upper limits of particle size and viscosity may vary with the design of the apparatus, and as finer liquid droplets are used, the limits become more strict.

Furthermore, since metal surfaces possess high activation energy, in the preparation of a dispersion liquid containing metal nanoparticles having metal surfaces, it is difficult to disperse the nanoparticles without any dispersant. Thus, conventionally, in order to achieve such purposes, a dispersion liquid prepared by dispersing particles after treating the particle surfaces with a dispersant, has been used (see, for example, Patent Documents 2 to 10). Particularly, in the case of copper nanoparticles, surface treatments are effective even in order to prevent oxidation of the particles, and from this viewpoint, various protective dispersants have been used (see, for example, Patent Documents 11 and 12).

It is known that in a dispersion liquid prepared by dispersing particles after treating the particle surfaces with a dispersant, particles having an average particle size of single-digit nanometers can be dispersed without aggregation. However, in an ink using a dispersant, it is needed, at the time of conductorization, to bring the particles into contact by removing the dispersant. Therefore, a large amount of energy is required, and combined use with heating to a temperature of 200°C or higher or heating by energy radiation is needed (see, for example, Patent Documents 13 and 14). In regard to the formation of a wiring pattern, since conductorization is carried out by heating the wiring pattern in the state in which a layer containing copper nanoparticles has been formed on the substrate, a highly heat resistant substrate is required so that the substrate can withstand high heat. In this view, there is a problem that there are limitations on the substrate that can be used.

Furthermore, there is also a problem that the volumetric shrinkage accompanying the detachment of the dispersant causes cracks or peeling of the conductor layer, and thus conduction cannot be obtained.

Under such circumstances, there has been a demand for an ink for printing processes in which particles of Cu and/or Cu oxides having a fine particle size are dispersed without aggregation, without using any dispersant.

In this regard, the inventors of the present invention found that nanoparticles having copper oxide surfaces can be dispersed without using a dispersant, by using a solvent which is highly polar and has no hydrogen bondability (see, for example, Patent Document 15). However, for copper oxide nanoparticles from a different source of acquisition, it has been a problem that there occur a problem of dispersibility that the nanoparticles cannot be dispersed, and a problem of dispersion stability that precipitation occurs or a supernatant is generated due to separation of the particles (see, for example, Patent Documents 14 and 15). Therefore, only limited types of particles can be used in Cu-based inks for printing processes, and there has been room for an improvement.

US-A1-2010/0233011 and US-A1-2012/0125659 describe an ink comprising metal nanoparticles having a carbon content in the total solids content of 0.4% by mass or less.

CITATION LIST

PATENT DOCUMENTS

Patent Document 1: Japanese Patent No. 2561537
Patent Document 2: Japanese Patent Application Laid-Open (JP-A) No. 2003-334618
Patent Document 3: JP-ANo. 2003-311944
Patent Document 4: Japanese Patent No. 3764349
Patent Document 5: WO2005/025787
Patent Document 6: JP-A No. 2004-211108
Patent Document 7: JP-A No. 2008-127679
Patent Document 8: JP-A No. 2008-88518
Patent Document 9: WO2006/019144
Patent Document 10: JP-ANo. 2008-138286
Patent Document 11: Japanese Patent No. 3953237
Patent Document 12: JP-A No. 2004-315853
Patent Document 13: JP-A No. 2009-215501
Patent Document 14: JP-A No. 2004-119686
Patent Document 15: JP-A No. 2007-83288

SUMMARY OF THE INVENTION

PROBLEM TO BE SOLVED BY THE INVENTION

The present invention was made in view of the above-described problems of the related art, and is intended to achieve the objects described below.

That is, an object of the present invention is to provide a producing process for an ink for printing processes which ink includes metal nanoparticles containing Cu and/or CuO and/or $Cu_2O$ (hereinafter, may be referred to as "Cu-based nanoparticles") and other metal nanoparticles, and which exhibits satisfactory dispersibility and sustained dispersion stability without using additives such as a dispersant.

MEANS FOR SOLVING PROBLEM

In regard to the problem that when the type of Cu-based nanoparticles is different, dispersibility and dispersion stability are not obtained, the inventors of the present invention contemplated that the problem is caused by any one of the following factors: 1. the oxygen-deprived state of cupric oxide at the surfaces of Cu-based nanoparticles, 2. adhesion of organic impurities, 3. the difference in the amount of adsorbed moisture, and 4. the difference in the amount of ionic impurities. Thus, the inventors conducted investigations respectively on the following factors: 1. the effect of surface oxidation as a result of heating at 200°C in air, 2. a cleaning treatment for the Cu particle surfaces by an RF plasma treatment, 3. vacuum drying, or drying of Cu-based nanoparticle powder by heating and drying under nitrogen, and 4. quantification of ionic impurities using ion chromatography. The inventors confirmed that the factors (1) to (3) do not affect the dispersibility and dispersion stability of the particles, and found that there is a correlation between the other factor, that is, the amount of ionic impurities, and the dispersibility and dispersion stability, thus completing the present invention.

The inventors found that in addition to a decrease in the amount of ionic impurities, when the absolute value of the zeta-potential of the dispersion liquid is 30 mV or higher, a metal nanoparticle dispersion liquid having high dispersibility and dispersion stability is obtained.

Furthermore, the inventors conducted a detailed investigation on the defects such as described above, and as a result, they found that when metal nanoparticles having a volume average particle size of the primary particles, D (nm), and a dispersion medium are incorporated, and when the average interparticle distance, L (nm), between the metal nanoparticles satisfies the relation: $1.6 \leq L/D \leq 3.5$, an ink for printing processes having excellent dispersibility is obtained without using a dispersant.

In addition, when this ink for printing processes is used, drawing of wiring by a printing process that is represented by an inkjet method can be carried out, and desired wiring patterns can be formed without the patterning process after film formation.

Specifically, the present invention that solves the problems described above is as follows.

(1) Producing process for an ink for printing processes, comprising a step to use at least metal nanoparticles, and to set up to have a carbon atom content in the total solids content of 0.4 mass% or less, the metal nanoparticles containing Cu and/or CuO and/or $Cu_2O$, and further comprising a step to set up the amount of ionic impurities to 2600 ppm or less in the total solids content, further comprising a step to set up the absolute value of the zeta potential to be 30 mV or greater.

(2) The producing process for an ink for printing processes according to (1), wherein the amount of ionic impurities is set up to 1600 ppm or less in a dry powder of the metal nanoparticles, and the ink is prepared in a step of dispersing metal nanoparticles containing Cu and/or CuO and/or $Cu_2O$ in a dispersion medium.

(3) The producing process for an ink for printing processes according to any one of (1) or (2), comprising a step to set up the 90% dispersion particle size of the metal nanoparticles containing Cu and/or CuO and/or $Cu_2O$ to be equal to or greater than 10 nm and equal to or less than 500 nm.

(4) The producing process for an ink for printing processes according to any one of (1) to (3), comprising a step to set up the volume average particle size of the metal nanoparticles to be equal to or greater than 2 nm and equal to or less than 500 nm.

(5) The producing process for an ink for printing processes according to any one of (1) to (4), comprising the step of dispersing the metal nanoparticles containing Cu and/or CuO and/or $Cu_2O$ in a dispersion medium having a vapor pressure at 25°C of less than $1.34 \times 10^3$ Pa, and the viscosity at 25°C is set up to be 50 mPa·s or less.

(6) The producing process for an ink for printing processes according to (5), the dispersion medium being an organic polar solvent in which the polar term in the Hansen solubility parameter is 11 $MPa^{0.5}$ or greater.

(7) The producing process for an ink for printing processes according to (1), comprising a step of providing metal nanoparticles having a volume average particle size of the primary particles of D (nm) and a dispersion medium, wherein when the average interparticle distance between adjacent metal nanoparticles in the ink for printing processes is designated as L (nm), the relation: $1.6 \leq L/D \leq 3.5$ is satisfied, and the dispersion medium being such that the polar term in the Hansen solubility parameter is 11 $MPa^{0.5}$ or greater.

(8) The producing process for an ink for printing processes according to (7), comprising a step to set up the volume average particle size (D) of the primary particles of the metal nanoparticles to be 10 to 300 nm.

(9) The producing process for an ink for printing processes according to (7) or (8), comprising the step of forming the metal nanoparticles from one kind, or a mixture of two or more kinds, of at least one or more element selected from Cu, Ag, Au, Al, Ni, Co, Pd, Sn, Pb, In and Ga, and/or partial or total oxides thereof.

(10) The producing process for an ink for printing processes according to any one of (7) to (9), comprising the step of preparing the ink without using a dispersant for the metal nanoparticles.

(11) The producing process for an ink for printing processes according to any one of (7) to (10), wherein the viscosity at 25°C is set up to be 0.1 to 50 mPa·s.

(12) The producing process for an ink for printing processes according to any one of (1) to (11), wherein the printing process is plateless printing process.

EFFECT OF THE INVENTION

According to the present invention, there can be provided an ink for printing processes which includes metal nanoparticles containing Cu and/or CuO and/or $Cu_2O$ and other metal nanoparticles, and which exhibits satisfactory dispersibility without using additives such as a dispersant.

BRIEF DESCRIPTION OF THE DRAWINGS

FIG. 1 is a drawing-substituted photograph showing the image of a pattern printed using the ink for printing processes of Example 1;
FIG. 2 is a schematic diagram of a hot wire type atomic hydrogen treatment apparatus;
FIG. 3 is a cross-sectional diagram of a coated substrate on which an ink for printing processes according to an Example of the present invention has been applied;
FIG. 4 is a cross-sectional diagram of the wiring, electroless plated layer and/or electroplated layer of the present invention; and
FIG. 5 is drawing-substitute photographs showing the external appearance of an ink for printing processes-coated substrate before and after a reduction treatment by a hot wire type atomic hydrogen treatment apparatus.

BEST MODES FOR CARRYING OUT THE INVENTION

<Ink for printing processes>

The ink for printing processes obtained according to the present invention is characterized in that the content of the carbon atoms in the total solids content is 0.4 mass% or less.

That is, the process of the present invention is characterized by not using a dispersant, a protective agent and the like. The ink does not contain carbon derived from a dispersant, a protective agent and the like. Therefore, the carbon content is very small. In other words, dispersants, protective agents and the like are usually carbon-containing compounds, which are organic compounds; however, since the process of the present invention does not use them, the ink for printing processes has a very small carbon content. Specifically, the carbon content is 0.4 mass% or less, and the lower limit is usually 0.01 mass%, and ideally 0.00 mass%.

Meanwhile, the carbon content can be measured by a high frequency induction-heated combustion-infrared absorption method. As the measuring apparatus, EMIA-V series manufactured by Horiba, Ltd. can be used.

Since the process of the present invention does not use a dispersant, a protective agent or the like as described above, there is a concern about whether dispersibility and dispersion stability can be secured. However, in the first embodiment and second embodiment described below, which are practical embodiments of the present invention, the conditions in which dispersibility and dispersion stability become satisfactory have been found.

Now, the first embodiment and the second embodiment of the processes of the present invention will be described below.

[Process of first embodiment]

The ink for printing processes obtained according to the first embodiment of the present invention is characterized in that the content of carbon atoms in the total solids content is 0.4 mass% or less, the ink for printing processes includes metal nanoparticles containing Cu and/or CuO and/or $Cu_2O$, and the amount of ionic impurities is 2600 ppm or less in the total solids content.

In the present invention, when an ink for printing processes is prepared using metal nanoparticles containing Cu and/or CuO and/or $Cu_2O$ with a predetermined amount of ionic impurities, a dispersion medium, and optionally additives, satisfactory dispersibility is obtained even without using additives such as a dispersant. Since a dispersant is not used, sintering of copper particles occurs without requiring a large amount of energy for removing the dispersant, and during the formation of a wiring pattern, the ink for printing processes can be used even on substrates having low heat resistance, so that the range of choice for the substrate can be widened.

First, metal nanoparticles containing Cu and/or CuO and/or $Cu_2O$ for the producing process for the ink for printing processes of the present invention, which are particles having a core/shell structure with the core part formed of copper and the shell part formed of copper oxides, and/or particles formed of copper oxides, will be described below.

[Copper/copper oxide core-shell particles]

For the particles having a core/shell structure with the core part formed of copper and the shell part formed of copper oxides (hereinafter, referred to as "copper/copper oxide core-shell particles"), for example, use can be made of particles produced by irradiating raw material metal compounds that are dispersed in an organic solvent which does not exhibit reducing action, with laser light under stirring. Furthermore, copper/copper oxide core-shell particles produced by introducing copper raw material into a plasma flame in an inert gas, and rapidly cooling the copper raw material with an inert gas for cooling, can also be used. The characteristics of the copper/copper oxide core-shell particles produced by using laser light can be controlled by appropriately selecting various conditions such as the type of the raw material copper compound, the particle size of the raw material copper compound, the amount of the raw material copper compound, the type of the organic solvent, the wavelength of the laser light, the output power of the laser light, the time of laser light irradiation, temperature, the agitated state of the copper compound, the type of the bubbling gas introduced into the organic solvent, the amount of the bubbling gas, and additives.

The amount of the ionic impurities included in the copper/copper oxide core-shell particles is limited to 2600 ppm or less, and preferably to 1500 ppm or less, from the viewpoint that if the amount of ionic impurities included in the ink for printing processes is large, dispersion stability is decreased.

The ionic impurities included in the copper/copper oxide core-shell particles can be analyzed by adding ultrapure water to dried copper/copper oxide core-shell particles in an amount 10 times the weight of the particles, sealing the mixture in a container made of Teflon (registered trademark), subjecting the mixture to extraction at 120°C for 24 hours, separating the particles by centrifugation, and subjecting the separated supernatant to ion chromatography. The amount of ionic impurities can be quantitatively determined by making reference to the results previously obtained and a calibration curve produced using standard solutions.

In regard to the copper/copper oxide core-shell particles used in the present invention, since coarse particles may cause clogging of pipes or inkjet heads, the 90% dispersion particle size in the dispersed state is preferably equal to or greater than 10 nm and equal to or less than 500 nm, more preferably equal to or greater than 10 nm and equal to or less than 300 nm, and even more preferably equal to or greater than 10 nm and equal to or less than 200 nm.

[Copper oxide particles]

As the particles formed of copper oxides (hereinafter, referred to as "copper oxide particles"), those available as commercially marketed products, such as copper oxide nanoparticles manufactured by C.I. Kasei Co., Ltd., that are produced by a gas phase evaporation method; and copper oxide nanoparticles manufactured by Nissei Engineering, Inc., that are produced by a plasma flame method, may be used.

In regard to the amount of the ionic impurities contained in the copper oxide particles, from the viewpoint that if the amount of the ionic impurities included in the ink for printing processes is large, dispersion stability is decreased, the total sum of the amounts of all ionic impurities that are included in the raw materials is limited to 2600 ppm or less, and preferably to 1500 ppm or less.

The ionic impurities included in the copper oxide particles can be analyzed by adding ultrapure water to dried copper/copper oxide core-shell particles in an amount 10 times the weight of the particles, sealing the mixture in a Teflon (registered trademark) container, subjecting the mixture to extraction at 120°C for 24 hours, separating the particles by centrifugation, and subjecting the separated supernatant to ion chromatography. The amount of ionic impurities can be quantitatively determined by making reference to the results previously obtained and a calibration curve produced using standard solutions.

In regard to the copper oxide particles used in the present invention, since coarse particles may cause clogging of pipes or inkjet heads, the 90% dispersion particle size in the dispersed state is preferably equal to or greater than 10 nm and equal to or less than 500 nm, more preferably equal to or greater than 10 nm and equal to or less than 300 nm, and even more preferably equal to or greater than 10 nm and equal to or less than 200 nm.

When the metal nanoparticles containing Cu and/or CuO and/or $Cu_2O$ used in the present invention as described above are dispersed in a dispersion medium that will be described below, the ink for printing processes of the present invention can be obtained. The dispersion medium according to the present invention will be described below.

Meanwhile, when the ink for printing processes is prepared by dispersing the metal nanoparticles described above in a dispersion medium, specifically, a dry powder of metal nanoparticles is dispersed in the dispersion medium, and the amount of ionic impurities in the dry powder of metal nanoparticles is preferably 1600 ppm or less, more preferably 1200 ppm or less, and even more preferably 900 ppm or less. Here, the term "dry powder of metal nanoparticles" means metal nanoparticles in the state that the dispersion medium is not included.

[Dispersion medium]

As the dispersion medium that disperses the metal nanoparticles containing Cu and/or CuO and/or $Cu_2O$ used in the producing process for the ink for printing processes of the present invention, it is preferable to use a dispersion medium having a vapor pressure at 25°C of less than 1.34x $10^3$ Pa. Such a dispersion medium can suppress an increase in the ink viscosity due to volatilization of the dispersion medium.

For example, if there is only a dispersion medium having a vapor pressure at 25°C of 1.34x $10^3$ or higher, the increase in the ink viscosity due to volatilization of the dispersion medium is significant, and for example, in an inkjet printing method, it becomes difficult to discharge liquid droplets from the nozzles of an inkjet head, while there is a tendency that clogging of the inkjet head is prone to occur. Furthermore, in an offset printing method, cob-webbing occurs in the step of removing unnecessary parts of a pattern from an ink-applied surface applied on a plate cylinder, or in the step of transferring ink from the plate cylinder onto a print-receiving object, and inconveniences are caused, as satisfactory pattern formation cannot be achieved.

In addition, a dispersion medium having a vapor pressure of less than $1.34 \times 10^3$ Pa and a dispersion medium having a vapor pressure of $1.34 \times 10^3$ Pa or greater may be used together. However, in that case, the mixing ratio of the solvent having a vapor pressure of $1.34 \times 10^3$ Pa or greater is preferably set to 60 mass% or less, more preferably 50 mass% or less, and even more preferably 40 mass% or less, relative to the total mass of the dispersion medium. Meanwhile, as the dispersion medium, various media can be used as long as they have a vapor pressure in the desired range and can disperse or dissolve insulating resins.

Specific examples of the dispersion medium having a vapor pressure at 25°C of less than $1.34 \times 10^3$ Pa include aliphatic hydrocarbon solvents such as nonane, decane, dodecane, and tetradecane; aromatic hydrocarbon solvents such as ethylbenzene, anisole, mesitylene, naphthalene, cyclohexylbenzene, diethylbenzene, phenylacetonitrile, phenylcyclohexane, benzonitrile, and mesitylene; ester solvents such as isobutyl acetate, methyl propionate, ethyl propionate, γ-butyrolactone, glycol sulfite, ethyl lactate, and ethyl lactate; alcohol solvents such as 1 -butanol, cyclohexanol, α-terpineol, and glycerin; ketone solvents such as cyclohexanone, 2-hexanone, 2-heptanone, 2-octanone, 1,3-dioxolan-2-one, and 1,5,5-trimethylcyclohexen-3-one; alkylene glycol solvents such as diethylene glycol ethyl ether, diethylene glycol diethyl ether, propylene glycol monomethyl ether, propylene glycol monoethyl ether, propylene glycol monopropyl ether, propylene glycol monobutyl ether, propylene glycol monomethyl ether acetate, diethylene glycol ethyl ether acetate, diethylene glycol propyl ether acetate, diethylene glycol isopropyl ether acetate, diethylene glycol butyl ether acetate, diethylene glycol t-butyl ether acetate, triethylene glycol methyl ether acetate, triethylene glycol ethyl ether acetate, triethylene glycol propyl ether acetate, triethylene glycol isopropyl ether acetate, triethylene glycol butyl ether acetate, triethylene glycol t-butyl ether acetate, dipropylene glycol dimethyl ether, and dipropylene glycol monobutyl ether; ether solvents such as dihexyl ether, butyl phenyl ether, pentyl phenyl ether, methoxytoluene, and benzyl ethyl ether; carbonate solvents such as propylene carbonate, and ethylene carbonate; amide solvents such as N,N-dimethylformamide, N,N-dimethylacetamide, and N-methylpyrrolidone; and nitrile solvents such as malononitrile. Furthermore, specific examples of the dispersion medium having a vapor pressure at 25°C of $1.34 \times 10^3$ Pa or greater include methyl ethyl ketone, methyl isobutyl ketone, toluene, isopropyl alcohol, and the like. These dispersion media can be used singly, or in combination of two or more kinds.

The content proportion of the dispersion medium in the ink for printing processes is not particularly limited, and the content proportion is appropriately adjusted such that the viscosity at 25°C and the surface tension of the ink are in the ranges that will be described below. However, usually it is preferable to adjust the content proportion to 40 to 99 mass% relative to the mass of the ink.

Furthermore, as the dispersion medium that disperses the copper/copper oxide core-shell particles or copper oxide particles used in the producing process for the ink for printing processes of the present invention, a dispersion medium in which the polar term in the Hansen solubility parameter is 11 MPa$^{1/2}$ or greater, as described in JP-A No. 2009-215501, is used, and it is preferable, in view of dispersibility, to use a dispersion medium in which the hydrogen bonding term in the Hansen solubility parameter is 8 MPa$^{1/2}$, and the polar term in the Hansen solubility parameter is 11 MPa$^{1/2}$.

Here, the Hansen solubility parameter is one of the methods for defining the solubility parameter of a solvent, and the details thereof are described in, for example, "INDUSTRIAL SOLVENTS HANDBOOK" (PP. 35-68, Marcel Dekker, Inc., published in 1996), "HANSEN SOLUBILITY PARAMETERS: A USER'S HANDBOOK" (pp. 1-41, CRC Press, 1999), "DIRECTORY OF SOLVENTS" (pp. 22-29, Blackie Academic & Professional, published in 1996), and the like. The Hansen solubility parameter is a parameter intrinsic to a substance, which has been introduced to estimate the affinity of a solvent and a solute, and the question of whether, when a certain solvent and a solute are brought into contact, the free energy of the system would decrease or increase to what extent, can be speculated from this parameter. That is, a solvent capable of dissolving a certain substance has parameters in a certain. The inventors of the present invention thought that the same applies to the relation between the metal particle surfaces and the dispersion medium. That is, the inventors suspected that when metal nanoparticles and a dispersion medium are brought into contact, in order to stabilize the system in terms of energy, the dispersion medium has a solubility parameter in a certain range.

Examples of a dispersion medium which satisfies the above-described conditions include γ-butyrolactone, N-methylpyrrolidone, propylene carbonate, ethylene carbonate, ethylene glycol sulfite, acetonitrile, and the like. Among them, particularly, γ-butyrolactone, propylene carbonate, and ethylene glycol sulfite are preferred.

Examples of a dispersion medium which satisfies all the above-described conditions of vapor pressure and Hansen solubility parameter include γ-butyrolactone, N-methylpyrrolidone, propylene carbonate, ethylene carbonate, and glycol sulfite.

In regard to the amount of the ionic impurities included in the dispersion medium, from the viewpoint that if the amount of the ionic impurities included in the ink for printing processes is large, dispersion stability is decreased, the total sum of the amounts of all ionic impurities that are included in the raw materials is preferably 2600 ppm or less, and more preferably 1500 ppm or less.

The amount of ionic impurities included in the dispersion medium can be determined by ion chromatography. Specifically, a dispersion medium is dried by heating or under reduced pressure in a container made of Teflon (registered trademark), ultrapure water is poured on the residue to dissolve out ionic impurities, and the ionic impurities can be analyzed by ion chromatography. The amount of ionic impurities can be quantitatively determined by making reference to the results previously obtained and a calibration curve produced using standard solutions.

In regard to the producing process for the ink for printing processes of the present invention, as described above, a dispersant which requires high energy to remove from surfaces of copper particles is not needed in the preparation of the ink for printing processes, but to the extent that the effects of the present invention are not impaired, a dispersant may be used without any problem in an amount equivalent to a carbon content of 0.4 mass% or less, for the purpose of further enhancing dispersion stability, or the like. For example, a surface tension adjusting agent can be used so as to make the ink for printing processes suitable for a printing apparatus for drawing wiring patterns.

Dispersion of the particles can be carried out by using an ultrasonic dispersing machine; a medium dispersing machine such as a bead mill; a cavitation stirring apparatus such as a homomixer or a Silverson stirrer; a counter collision method such as an Ultimaizer; an ultrathin film high-speed rotary dispersing machine such as Crea SS5; a rotary and revolutionary mixer, or the like.

The concentration of the particles in the ink for printing processes is preferably adjusted to 1 to 70 wt%, more preferably 5 to 60 wt%, and even more preferably to 10 to 50 wt%.

It can be contemplated that when the particles of the producing process for the ink for printing processes are not dispersion stabilized by a dispersant or a surface treating agent, the particles are dispersion stabilized in the dispersion medium by means of the repulsive force due to the zeta-potential at the particle surfaces. In such a system, when a substance having an electric charge that is coupled with zeta potential is present, it is expected that neutralization of zeta potential or shortening of the operating distance occurs, and dispersion stability is decreased. Examples of a substance having such an electric charge include bases, acids, and salts thereof, and ions resulting from dissociation of those substances include anions and cations. According to the present invention, the ionic impurities collectively refer to the bases, acids, salts thereof, anions, and cations included in the ink for printing processes.

Examples of dissociated ions that can be detected by ion chromatography when the ionic impurities are extracted with pure water include, but are not limited to, the following: hydrogen ion ($H^+$), lithium ion ($Li^+$), sodium ion ($Na^+$), potassium ion ($K^+$), silver ion ($Ag^+$), copper(I) ion ($Cu^+$), mercury(I) ion ($Hg^+$), oxonium ion ($H_3O^+$), ammonium ion ($NH_4^+$), diamminesilver ion ($[Ag(NH_3)_2]^+$), violeo ($[CoCl_2(NH_3)_4]^+$), magnesium ion ($Mg^{2+}$), calcium ion ($Ca^{2+}$), strontium ion ($Sr^{2+}$), barium ion ($Ba^{2+}$), cadmium ion ($Cd^{2+}$), nickel(II) ion ($Ni^{2+}$), zinc ion ($Zn^{2+}$), copper(II) ion ($Cu^{2+}$), mercury(II) ion ($Hg^{2+}$), iron(II) ion ($Fe^{2+}$), cobalt(II) ion ($Co^{2+}$), tin(II) ion ($Sn^{2+}$), lead(II) ion ($Pb^{2+}$), manganese(II) ion ($Mn^{2+}$), tetraamminezinc(II) ion ($[Zn(NH_3)_4]^{2+}$), tetraamminecopper(II) ion ($[Cu(NH_3)_4]^{2+}$), tetraaquacopper(II) ion ($[Cu(H_2O)_4]^{2+}$), thiocyanoiron(III) ion ($[Fe(SCN)]^{2+}$), hexaamminenickel(II) ion ($[Ni(NH_3)_6]^{2+}$), purpureo ($[CoCl(NH_3)_5]^{2+}$), aluminum ion ($Al^{3+}$), iron(III) ion ($Fe^{3+}$), chromium(III) ion ($Cr^{3+}$), hexaamminecobalt(III) ion ($[Co(NH_3)_6]^{3+}$), hexaaquacobalt(III) ion ($[Co(H_2O)_6]^{3+}$), hexaamminechromium(III) ion ($[Cr(NH_3)_6]^{3+}$), roseo($[Co(NH_3)_4(H_2O)_2]^{3+}$), tin(IV) ion ($Sn^{4+}$), hydride ion ($H^-$), fluoride ion ($F^-$), chloride ion ($Cl^-$), bromide ion ($Br^-$), iodide ion ($I^-$), hydroxide ion ($OH^-$), cyanide ion ($CN^-$), nitride ion ($NO_3^-$), nitrite ion ($NO_2^-$), hypochlorite ion ($ClO^-$). chlorite ion ($ClO_2^-$), chlorate ion ($ClO_3^-$), perchloriate ion ($ClO_4^-$), permanganate ion ($MnO_4^-$), acetate ion ($CH_3COO^-$), hydrogen carbonate ion ($HCO_3^-$), dihydrogen phosphate ion ($H_2PO_4^-$), hydrogen sulfate ion ($HSO_4^-$), hydrogen sulfide ion ($HS^-$), thiocyanate ion ($SCN^-$), tetrahydroxoaluminate ion ($[Al(OH)_4]^-$, $[Al(OH)_4(H_2O)_2]^-$), dicyanoargentate(I) ion ($[Ag(CN)_2]^-$), tetrahydroxochromate(III) ion ($[Cr(OH)_4]^-$), tetrachloroaurate(III) ion ($[AuCl_4]^-$), oxide ion ($O^{2-}$), sulfide ion ($S^{2-}$), peroxide ion ($O_2^{2-}$), sulfate ion ($SO_4^{2-}$), sulfite ion ($SO_3^{2-}$), thiosulfate ion ($S_2O_3^{2-}$), carbonate ion ($CO_3^{2-}$), chromate ion ($CrO_4^{2-}$), dichromate ion ($Cr_2O_7^{2-}$), monohydrogen phosphate ion ($HPO_4^{2-}$), tetrahydroxozincate(II) ion ($[Zn(OH)_4]^{2-}$), tetracyanozincate(II) ion ($[Zn(CN)_4]^{2-}$), tetrachlorocuprate(II) ion ($[CuCl_4]^{2-}$), phosphate ion ($PO_4^{3-}$), hexacyanoferrate(III) ion ($[Fe(CN)_6]^{3-}$, bis(thiosulfato)argentate(I) ion ($[Ag(S_2O_3)_2]^{3-}$), hexacyanoferrate(II) ion ($[Fe(CN)_6]^{4-}$), and the like.

The amount of the ionic impurities included in the ink for printing processes of the present invention is 2600 ppm relative to the total solids content, as described above, and examples of the technique for adjusting the amount of ionic impurities to the relevant range include deionization treatment using ion exchange resin, dialysis, and the like. Alternatively, the amount of the ionic impurities can also be adjusted to the range described above, by taking caution to prevent ionic impurities from being incorporated during the production of metal nanoparticles, and to prevent nitrogen, halogen, alkali metals and the like from being included. It is important not only to eliminate the ionic impurities from raw materials, but also to eliminate elements that produce ionic components from the atmosphere because, in the case of using a treatment generating radicals, such as sputtering or plasma, if nitrogen and carbon dioxide gas are incorporated into the atmosphere, they generate nitrate ions and carboxylate ions, respectively.

The amount of the ionic impurities included in the ink for printing processes can be determined by ion chromatography. Furthermore, it is also possible to indirectly estimate the amount of ionic impurities by detecting elements originating from the ionic impurities by a fluorescence X-ray analysis.

Quantification of the amount of ionic impurities by ion chromatography can be carried out by drying the ink for printing processes under reduced pressure or by heating, subsequently adding ultrapure water in an amount of 10 times the weight of the dried product, sealing the mixture in a container made of Teflon (registered trademark), subjecting the mixture to extraction at 120°C for 24 hours, and analyzing the supernatant separated by centrifugation by ion chromatography. The amount of ionic impurities can be quantitatively determined by making reference to the results previously obtained and a calibration curve measured and produced using standard solutions.

For the producing process for the ink for printing processes of the present invention, in order to further enhance dispersibility and dispersion stability, it is preferable to set the absolute value of the zeta potential to 30 mV or higher, in addition to the reduction of the amount of ionic impurities. Furthermore, the absolute value of the zeta potential is preferably 35 mV or higher, and more preferably 40 mV. Furthermore, the absolute value is preferably 200 mV or lower. If the absolute value of the zeta potential is less than 30 mV, there is a risk that the dispersion stability of the metal nanoparticles may decrease. Meanwhile, the zeta potential can be measured by using, for example, a zeta potential analyzer (manufactured by Beckman-Coulter, Inc., Delsa 440SX) or the like.

Furthermore, in this case, the metal nanoparticles such as the copper/copper oxide core-shell particles or copper oxide particles are such that, from the viewpoint that large particles are prone to settle under their own weight and it is difficult to achieve dispersion stabilization, the volume average particle size at the time of dispersion is preferably equal to or greater than 2 nm and equal to or less than 500 nm, more preferably 2 nm to 300 nm, and even more preferably 2 nm to 200 nm.

The ink for printing processes obtained according to the present invention can be used in non-contact printing processes such as an inkjet printing method and a dispenser printing method; planographic printing such as an offset printing method; stencil printing such as a screen printing method; intaglio printing such as gravure printing; and the like.

The viscosity (dynamic viscosity) of the ink for printing processes is preferably 50 mPa·s or less at 25°C. If the viscosity of an insulator ink is 50 mPa·s or less, the occurrence of a non-discharge nozzle at the time of inkjet printing or the occurrence of clogging in the nozzle can be more surely prevented. The viscosity of the insulator ink is more preferably 1.0 to 30 mPa·s at 25°C. When the ink viscosity is adjusted to this range, there is a tendency that liquid droplets can be made to have small diameters, and the impact diameter of the ink can be further decreased.

Therefore, as described above, when a dispersion medium having a vapor pressure at 25°C of $1.34 \times 10^3$ Pa or greater is used, the viscosity of the ink for printing processes can be easily adjusted to the range described above, and therefore, it is preferable. That is, the ink for printing processes of the present invention is preferably such that metal nanoparticles containing Cu and/or CuO and/or $Cu_2O$ are dispersed in a dispersion medium having a vapor pressure at 25°C of less than $1.34 \times 10^3$ Pa, and the viscosity at 25°C is 50 mPa·s or less.

The surface tension at 25°C of the ink for printing processes obtained according to the present invention is preferably 20 mN/m or greater. If the surface tension is less than 20 mN/m, there is a tendency that the ink liquid droplets wet and spread over a base material after impact, and do not form a flat and smooth film. The surface tension of the insulator ink is more preferably in the range of 20 to 80 mN/m. This is because if the surface tension of the ink exceeds 80 mN/m, liquid droplets are pulled back in the inkjet nozzle due to the surface tension, and it becomes difficult to discharge the liquid droplets. The surface tension of the insulator ink is more preferably 20 to 50 mN/m.

Furthermore, if necessary, adjusting agents such as an ink surface tension adjusting agent, a coupling agent or an adhesive for imparting adhesive force to the substrate, an oxidation inhibitor, and the like may also be incorporated.

<Evaluation method>

As discussed above, if the amount of the ionic impurities contained in the metal nanoparticles containing Cu and/or CuO and/or $Cu_2O$ is 2600 ppm or less, an ink for printing processes exhibiting satisfactory dispersibility and dispersion stability can be prepared even without using a dispersant. From an opposite point of view, when the amount of ionic impurities in unknown metal nanoparticles containing Cu and/or CuO and/or $Cu_2O$ is measured, and it is checked if the amount is 2600 ppm or less or not, evaluations can be made on whether the dispersibility and dispersion stability of the metal nanoparticles are satisfactory, and also on whether a dispersant will be needed.

[Process of second embodiment]

The ink for printing processes obtained according to the second embodiment of the present invention is characterized in that the content of carbon atoms in the total solids content is 0.4 mass% or less; the ink for printing processes includes metal nanoparticles having a volume average particle size of primary particles, D (nm), and a dispersion medium; when the average interparticle distance between adjacent metal nanoparticles in the ink for printing processes is designated as L (nm), the relation: $1.6 \leq L/D \leq 3.5$ is satisfied; and the polar term in the Hansen solubility parameter of the dispersion medium is 11 $MPa^{0.5}$ or greater.

If the value of L/D is 1.6 or greater, it is preferable from the viewpoint that satisfactory dispersibility of metal nanoparticles and a sustained dispersion state are obtained without using a dispersant. Furthermore, if the value of L/D is greater than 3.5, the concentration of the metal nanoparticles in the dispersion medium is decreased, and during the process of forming wiring, the amount of adhesion of metal nanoparticles is reduced. For that reason, it is not preferable from a practical viewpoint because, for example, a printing process that is represented by an inkjet printing method must be repeated many times. Therefore, from the viewpoints of dispersibility and wiring formability, the relation is such that $1.6 \leq L/D \leq 3.5$. Furthermore, from the viewpoints of dispersibility and wiring formability, the relation is preferably such that $1.6 \leq L/D \leq 3.0$, and from the viewpoint of cutting down the number of printing operations represented by an inkjet printing method, the relation is more preferably such that $1.6 \leq L/D \leq 2.8$. The dispersant as used herein means an organic compound and/or inorganic compound that is made to adhere to the meal nanoparticles surfaces for the purpose of enhancing oxidation resistance, fusion resistance, and dispersibility.

The term L (nm) is defined as the average distance between the centers of metal nanoparticles, determined by using the following geometric approximation formula, and using a geometrically determined value of the average inter-surface distance between the primary particles of metal nanoparticles in a dispersion medium, Ls (nm), and the volume average particle size of the primary particles, D (nm):

$$L \, (nm) = D/2 + Ls \, (nm)$$

$$Ls \, (nm) = D \times [(1/3 \times \pi \times F + 5/6)^{0.5} - 1]$$

F = Volume of metal nanoparticles in ink for printing processes/volume of ink for printing processes

Meanwhile, the volume of the metal nanoparticles in the ink for printing processes and the volume of the ink for printing processes can be respectively calculated by dividing the mass by the density. According to the present invention, L (nm) is determined by the above formula, and then the value of L/D is determined.

In regard to the dispersion medium used in the producing process for the ink for printing processes, the polar term in the Hansen solubility parameter is defined as 11 MPa$^{0.5}$ or greater, in order to obtain satisfactory dispersibility of the metal nanoparticles and a sustained dispersion state without using a dispersant.

It is speculated that when a dispersant which satisfies these conditions is used, dispersibility of the particles is enhanced because the free energy is decreased due to the contact between the metal particle surfaces and the dispersion medium, and the dispersed state is stabilized.

Furthermore, the dispersion medium according to the present invention is such that the polar term in the Hansen solubility parameter is 11 MPa$^{0.5}$ or greater, and although it is indicated that the dispersion medium is highly polar, the polar term is preferably 12 MPa$^{0.5}$ or greater, and more preferably 13 MPa$^{0.5}$ or greater. If the polar term is less than 11 MPa$^{0.5}$, the dispersed system aggregates, and an increase in viscosity, settling of the particles, or separation of the particles and the dispersion medium may occur. Furthermore, the upper limit is usually 20 MPa$^{0.5}$.

Examples of the dispersion medium that satisfies the above-described conditions include water, dimethyl sulfoxide, N-methylpyrrolidone, γ-butyrolactone, propylene carbonate (propylene carbonate), ethylene carbonate (ethylene carbonate), butylene carbonate (butylene carbonate), ethylene glycol sulfite, sulfolane, malononitrile, phenylacetonitrile, acetonitrile, N-acetylpyrrolidone, acetyl fluoride, ammonia, 1,4-butanediol, 3-butenenitrile, cyclopentanone, N,N-dimethylacetamide, N,N-diethylacetamide, N,N-diethylformamide, diethyl sulfite, diethylene glycol, diethylenetriamine, N,N-diethylacetamide, diethyl sulfide, dimethylformamide, ethylideneacetone, formamide, glycerol, methyl isopentyl ketone, and phenylacetonitrile. Among them, particularly dimethyl sulfoxide, N-methylpyrrolidone, γ-butyrolactone, propylene carbonate (propylene carbonate), ethylene carbonate (ethylene carbonate), butylene carbonate (butylene carbonate), ethylene glycol sulfite, sulfolane, malononitrile, phenylacetonitrile, acetonitrile, acetyl chloride, N-acetylpyrrolidone, acetyl fluoride, acrylonitrile, cyclopentanone, N,N-diethylacetamide, diethyl sulfite, and phenylacetonitrile.

In addition, as a dispersion medium suitable for printing processes that are represented by an inkjet method, an organic solvent (solvent) having a vapor pressure at 25°C of less than $1.34 \times 10^3$ Pa is preferred. Specific examples have been illustrated in the first embodiment, and thus further description thereon will not be repeated here. These solvents can be used singly or in combination of two or more kinds. Furthermore, in addition to the above, a dispersion medium in which the polar term in the Hansen solubility parameter is 11 MPa$^{0.5}$ or greater is also a suitable dispersion medium, and a single dispersion medium can be used alone or two or more dispersion media can be used in combination, as long as the resulting vapor pressure at 25°C is less than $1.34 \times 10^3$ Pa.

Next, the metal nanoparticles will be explained below. The metal nanoparticles can use all of Cu, Ag, Au, Al, Ni, Co, Pd, Sn, Pb, In, Ga and oxides thereof, and may also contain small amounts of metal salts and metal complexes as impurities. The metal nanoparticles may be entirely made of a metal, or may be core-shell metal particles surrounded by an oxide, or particles in which almost the entirety is made of an oxide (for example, copper oxide). The particles may also be compounds of other elements, as long as electrical conductivity can be exhibited in a normal state or after a treatment. Further, particles formed of cuprous oxide and having a core/shell structure are more preferred since the particles can be easily reduced. As these metal nanoparticles, commercially available products may be used, or the metal nanoparticles can also be synthesized by using a known synthesis method. These metal nanoparticles can be used singly or in combination of two or more kinds.

In general, metals have high specific gravities, and when the particle size is large, metal particles easily settle under their own weight, and it is difficult to stably maintain a dispersed state. From this point of view, the primary particle size of the metal nanoparticles is preferably 1 to 300 nm as the volume average particle size, and from the viewpoint of dispersibility in the case of dispersing the metal nanoparticles without using a dispersant, the volume average particle size of the primary particles is more preferably 15 to 200 nm. In order to sustain satisfactory dispersibility and also to facilitate conductorization (lowering of resistivity) through a reduction treatment that will be described later, the volume average particle size of the primary particle is even more preferably 20 to 100 nm. The volume average particle size of the primary particle size is determined by a method of calculating the arithmetic average particle size from the particle size distribution of the volume fraction with respect to the particle size that is determined from the intensity of scattered light measured at 25°C according to a laser diffraction scattering method; or a method of calculating the particle size in the case where the particle shape is assumed to be truly spherical, with the specific gravity of the primary particles, from the measured value of the specific surface area according to a nitrogen adsorption BET method. However, in the case of measuring the average particle size in the state of powder, the latter method is commonly used. Furthermore, in a system dispersed in a solvent such as water, the former method is commonly used. The volume average particle size in that case can be determined by measuring the particle size distribution using a laser scattering type particle size distribution analyzer (manufactured by Beckman-Coulter, Inc., LS 13 320), but in some cases, aggregates such as secondary particles may also be included.

Furthermore, since the metal nanoparticles are applied by a printing process, the average dispersion particle size including secondary aggregates and the like is preferably 500 nm or less. If the average dispersion particle size is 200 nm or less, for example, in an inkjet printing method, inconveniences such as clogging of the nozzle do not easily occur, and thus it is more preferable. Particles having a dispersion particle size of 500 nm or greater may be present, but if the maximum dispersion particle size is 2000 nm or less, clogging and the like do not occur during inkjet printing, and it is preferable. Industrially, from the viewpoint of obtaining dispersion stability with higher general-purpose usability, the maximum dispersion particle size is more preferably 800 nm or less.

The dispersion of the metal nanoparticles to be applied in a printing process can be carried out using a general method of dispersing a powder in a liquid. For example, a dispersion treatment may be carried out by an ultrasonic method; a medium dispersion method such as a bead mill; a three-roll method, a homomixer or a Silverson stirrer; a counter collision method such as an Ultimaizer; an ultrathin film high-sped rotary dispersing machine such as Crea SS5; or a rotary and revolutionary mixer. These dispersion treatments may be carried out at room temperature (25°C), or may be carried out after heating in order to lower the viscosity of the dispersion liquid. If the melting point of the dispersion medium is high, it is preferable to carry out the above-described operation while the dispersion liquid is heated to a temperature at which the dispersion medium turns into liquid. Furthermore, in order to obtain a more stable dispersed state without making active fractured surfaces that are causative of aggregation on the surfaces of the metal nanoparticles, an ultrasonic method, a medium dispersion method such as a bead mill, and a rotary and revolutionary mixer are more preferred. These dispersion methods can be used singly or in combination of two or more kinds.

An ink for printing processes in which metal nanoparticles are dispersion treated in a dispersion medium by the above-described methods, can be prepared into a more stably dispersed state with a smaller average particle size, by subjecting the ink for printing processes to a centrifugal treatment. The speed of rotation and duration of centrifugation, which are centrifuge treatment conditions, may vary with the apparatus used, and therefore, conditions in which centrifugation can be carried out to obtain a sediment particle size of 1 $\mu$m or greater at the specific gravity of primary particles, are appropriately selected.

There are no particular limitations on the content proportion of the dispersion medium in the ink for printing processes, and it is preferable to appropriately adjust the content proportion of the dispersion medium so that the ratio L/D of the average interparticle distance, L (nm), between the metal nanoparticles at 25°C in the ink and the volume average primary particle size, D (nm), the viscosity and the surface tension are respectively in suitable ranges. However, usually, it is preferable to adjust the content ratio to 40 to 97 mass% relative to the mass of the ink for printing processes. In order to prepare the ink for printing processes as a low-viscosity dispersion liquid having a viscosity suitable for printing processes that are represented by an inkjet method, it is more preferable to adjust the content proportion of the dispersion medium to 50 to 90 mass% relative to the mass of the ink for printing processes, and in order to satisfactorily maintain the shape of the wiring formed by the printing processes, it is even more preferable to adjust the content proportion of the dispersion medium to 60 to 80 mass% relative to the mass of the ink for printing processes.

In order to obtain an ink for printing processes suitable for printing processes that are represented by an inkjet method, it is preferable that the viscosity at 25°C after a dispersion treatment be 0.1 to 50 mPa·s, and it is more preferable that the viscosity be 1 to 30 mPa·s, because the occurrence of non-discharge nozzles during inkjet printing, or clogging of nozzles can be more surely prevented. When the viscosity is 3 to 20 mPa·s, it is more preferable because stable dischargeability is maintained, and an ink for printing processes having higher general-purpose usability in an industrial viewpoint is obtained.

In the ink for printing processes, a surface adjusting agent may be appropriately added, in order to adjust the surface tension to be suitable for printing processes that are represented by an inkjet method. The surface tension at 20°C is preferably 20 to 80 mN/m in order to obtain satisfactory formability of wiring at the time of printing; more preferably 21 to 50 mN/m in order to obtain more suitable dischargeability in the case of printing by an inkjet method; and even more preferably 22 to 45 mN/m, from the viewpoint of the formability of flat and smooth wiring.

Examples of the surface adjusting agent include silicone compounds, vinyl compounds, acrylic compounds, fluorine compounds, and the like. These surface adjusting agents may be incorporated singly or in combination of two or more kinds.

<Metal nanoparticles>

The metal nanoparticles of the present invention are metal nanoparticles used in an ink for printing processes, and are characterized in that the amount of ionic impurities is 1000 ppm or less, the 90% particle size of primary particles is 200 nm or less, the volume average particle size is 100 nm or less, and the particle surface is formed of CuO or/and $Cu_2O$.

The metal nanoparticles of the present invention are appropriate for the preparation of the ink for printing processes of the present invention described above, and the ink for printing processes of the present invention can be prepared by dispersing those metal nanoparticles in a dispersion medium such as described above, and subjecting the dispersion to other processes as necessary.

Furthermore, the metal nanoparticles of the present invention have their particle surfaces formed of CuO or/and $Cu_2O$ from the viewpoint of the particle structure; however, these may be copper/copper oxide core-shell particles or copper oxide particles such as described above.

In regard to the metal nanoparticles of the present invention, when the 90% particle size of the primary particles is 200 nm or less, clogging of inkjet pipes or nozzles can be avoided. The 90% particle size of the primary particles is preferably 150 nm or less. The lower limit is usually 1 nm.

Meanwhile, the value of the 90% particle size is a value obtainable from images obtained by observation by TEM or SEM, or through measurement made by BET.

Furthermore, when the volume average particle size of the metal nanoparticles of the present invention is 100 nm or less, settling of the particles under their own weight can be suppressed. The volume average particle size is preferably 70 nm or less. The lower limit is usually 1 nm.

<Formation of wiring pattern>

Next, as an example of the method for forming a wiring pattern on a substrate using the ink for printing processes obtained according to the present invention, a method for forming a copper wiring pattern will be explained. First, the substrate that is used will be described.

[Substrate]

Specific examples of the material for the substrate used in the method for forming a wiring pattern include, but are not limited to, polyimide, polyethylene naphthalate, polyether sulfone, polyethylene terephthalate, polyamideimide, polyether ether ketone, polycarbonate, a liquid crystal polymer, an epoxy resin, a phenolic resin, a cyanate ester resin, a fiber-reinforced resin, polyolefin, polyamide, polyphenylene sulfide, a glass plate, and the like.

As described above, when the ink for printing processes obtained according to the present invention is used, a substrate having low heat resistance can be used, and thus, there are fewer limitations on the substrate to be used.

Next, the procedure of the method for forming a wiring pattern, and the details of the operations in the respective steps will be described in order.

The wiring is a dot-shaped, line-shaped or film-shaped print product produced by patterning an ink for printing processes by a printing process that is represented by an inkjet method, and is obtained by removing the dispersion medium, after printing, through a vacuum drying treatment, a heating and drying treatment or the like as necessary, and subjecting the dried ink to a sintering treatment or a reduction treatment so as to impart electrical conductivity. The thickness of the wiring is preferably 0.1 to 25 $\mu$m, and from the viewpoint of connection reliability, the thickness is more preferably 0.2 to 10 $\mu$m. In order to efficiently carry out the sintering treatment or the reduction treatment for imparting electrical conductivity, the thickness is even more preferably 0.4 to 3 $\mu$m.

As the printing processes of the ink for printing processes, for example, various printing processes such as a screen printing method, a letterpress printing method, an intaglio printing method, a transfer printing method, a gravure printing method, an inkjet printing method, a super inkjet printing method, a dispenser printing method, a needle dispenser printing method, a jet dispenser method, a nanoimprint printing method, a contact printing method, and a spin coat printing method can be applied. Among them, an inkjet printing method is preferred because a desired amount of ink can be printed on a desired position, without using a special plate, and the method has features such as the efficiency of material usage or the ease of coping with changes in the pattern design.

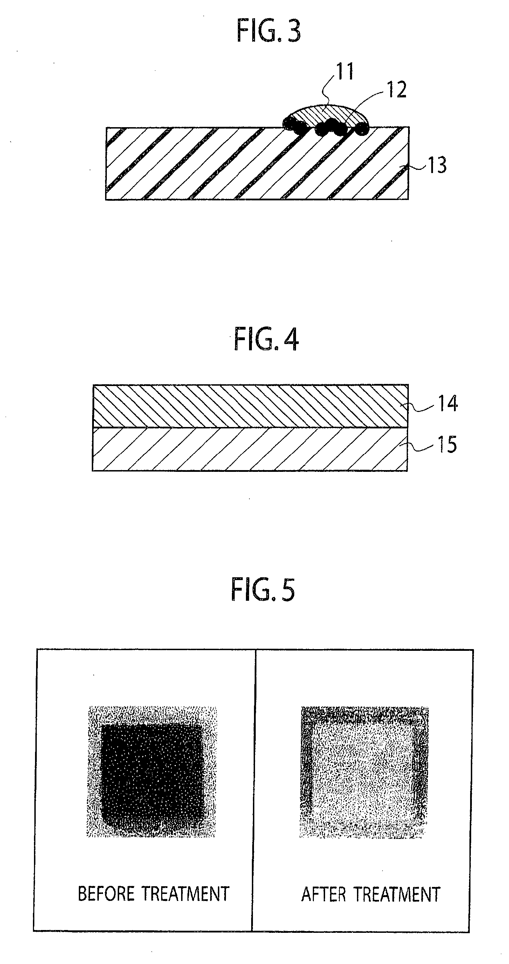

FIG. 3 is a cross-sectional diagram schematically showing a coated substrate on which the ink for printing processes is applied. Reference Numeral 11 represents wiring, reference numeral 12 represents a metal nanoparticle, and reference numeral 13 represents a substrate.

After a wiring pattern is drawn using the ink for printing processes obtained according to the present invention, drying is carried out at a temperature adjusted in accordance with the volatility of the dispersion medium. As the drying technique, a heating treatment method such as heating of the substrate or blowing of hot air can be employed. Such a drying treatment can be carried out, for example, at a heating temperature of 30°C to 200°C for a heating time of 0.1 to 2.0 hours. In addition to that, the dispersion medium can also be removed in an environment at a low pressure or in a vacuum. In this case, since the copper/copper oxide core-shell particles and the copper oxide particles all have surfaces formed of copper oxides, it is not necessary to dry the particles in an oxygen-deprived atmosphere, as in the case of the copper metal particles.

Subsequently, copper oxides of the copper/copper oxide core-shell particles and the copper oxide particles are reduced, and thereby copper metal is produced. The reduction treatment may be carried out by any method appropriate for the respective wiring types, and there are no particular limitations. The volume resistivity after reduction or sintering is preferably $1 \times 10^{-5}$ $\Omega \cdot m$ or less. When the volume resistivity is equal to or higher than this, there is a risk that the particles may not find a use as electrical wiring. From the viewpoint of obtaining satisfactory electrical conductivity, the volume resistivity is more preferably $1 \times 10^{-6}$ $\Omega \cdot m$ or less, and from the viewpoint of use as a suitable fine wiring with a reduced loss of electrical resistance of the wiring, the volume resistivity is even more preferably $1 \times 10^{-7}$ $\Omega \cdot m$ or less.

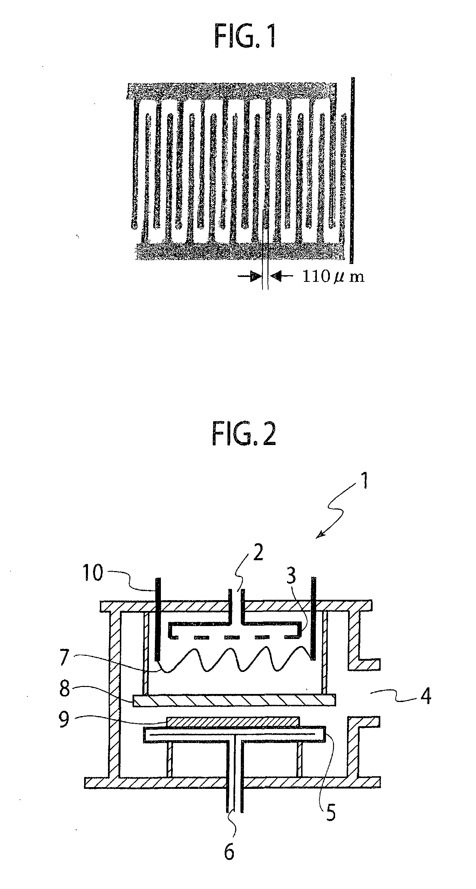

As the reduction treatment method, for example, in the case of a wiring layer using copper particles in which copper oxides have been incorporated into metal nanoparticles, a reduction method of using atomic hydrogen, or a reduction method of heating in a reducing gas atmosphere such as hydrogen or ammonia may be taken as examples. As a method for generating atomic hydrogen, a hot wire type atomic hydrogen treatment apparatus shown in FIG. 2 can be used. The pressure inside the apparatus is reduced to $10^{-3}$ Pa or less, and air inside the system is removed. Subsequently, a hydrogen-containing raw material gas containing hydrogen, ammonia, hydrazine and hydrazine is sent through a gas inlet port to a shower head for diffusing the gas into the chamber. When the gas diffused from the shower head is passed through, for example, a high-temperature catalyst body formed of a tungsten wire (when current is passed, heated to a high temperature, for example, 1700°C), the raw material gas is decomposed, and thereby atomic hydrogen is generated. Copper oxide particles are reduced by this atomic hydrogen, and sintering is achieved. Meanwhile, a shutter or a masking shield, which both have gaps that do not shield gas, is inserted between the catalyst body that is heated to a high temperature and the sample substrate, so that the substrate is not directly subjected to the radiant heat from the catalyst body. During this treatment, the temperature of the substrate shifts to 50°C or lower if the substrate is not directly subjected to the radiant heat from the catalyst body, or if the substrate holder is not heated. However, even at such a low temperature, fusion between reduced copper particles proceeds simultaneously with reduction. In addition to that, the copper particles can be reduced by atomic hydrogen generated by a vacuum plasma apparatus using RF or microwaves, or an atmospheric pressure plasma apparatus.

In addition to this, wiring having a desired volume resistivity can be obtained by a reduction method of using a reducing liquid and/or gas selected from alkylamineborane, hydrazine, a hydrazine compound, formaldehyde, an aldehyde compound, a phosphorous acid compound, a hypophosphorous acid compound, adipic acid, formic acid, alcohol, a tin(II) compound, tin metal, a hydroxylamine compound, and ascorbic acid.

When it is acknowledged that the reduction reaction has progressed to a certain extent by a reduction treatment method such as described above, the wiring is heated to a temperature at which the copper particles in the wiring can be sintered (hereinafter, referred to as "sintering temperature"). By maintaining this sintering temperature for a certain time period, the copper particles sinter with each other, and the overall wiring is conductorized (imparted with electrical conductivity). Meanwhile, when a dispersant is not used, the energy required to remove the dispersant is not necessary, and sintering can be achieved at a relatively low temperature. Furthermore, sintering may be carried out simultaneously with the reduction treatment, or in the case where conductorization can be sufficiently achieved only by the reduction treatment, sintering may not be carried out.

The sintering temperature is preferably 120°C to 300°C, and more preferably 130° to 250°C, from the viewpoint of obtaining satisfactory electrical conductivity, and is even more preferably 140°C to 200°C from the viewpoint of forming a wiring having low volume resistivity.

Furthermore, the upper limit of the treatment temperature is defined by the heat resistant temperature of the substrate. In the case of forming wiring on an organic substrate, the treatment temperature is preferably 280°C or lower, and from the viewpoint of the type of substrate that can be used, the treatment temperature is more preferably 200°C or lower.

The sintering time may vary with the retention temperature, but for example, the sintering time is preferably set to 0.5 to 60 minutes, and from the viewpoint of achieving an efficient sintering treatment process, it is more preferable to set the sintering time to 1 to 30 minutes. After sintering, the substrate on which a conductor layer has been formed may be exposed to ultrapure water or the like, and then dried over acetone or the like.

In this manner, a wiring which has excellent electrical conductivity in any form can be produced.

Furthermore, in the case of forming a thick film fine wiring, this wiring can be used as a seed layer for electroless plating, so that the wiring may be made thick by subjecting the wiring to electrolytic plating (see FIG. 4). FIG. 4 is a cross-sectional diagram of wiring and an electroless plated layer and/or an electroplated layer, and in FIG. 4, reference numeral 14 represents wiring, while reference numeral 15 represents an electroless plated layer and/or an electroplated layer.

Furthermore, a circuit board or a semiconductor package may also be produced by using the wiring described above in a portion or the entirety of a circuit as a circuit for electrical conduction. There are no particular limitations on the material of the circuit board or the semiconductor package, and any of a resin substrate and an inorganic substrate may be used.

EXAMPLES

Hereinafter, the present invention will be specifically described by way of Examples, but the present invention is not intended to be limited to these.

[Example 1]

(Preparation of inkjet ink)

27 g of copper oxide nanoparticles (cupric oxide, average primary particle size 74 nm, product name: Nanotek CuO®, manufactured by C.I. Kasei Co., Ltd.) was added to 73 g of γ-butyrolactone (concentration of copper oxide nanoparticles 27 mass%), and the mixture was treated with an ultrasonic homogenizer (US-600, manufactured by Nippon Seiki Co., Ltd.) at 19.6 kHz and 600 W for 5 minutes to thereby obtain a dispersion liquid. This dispersion liquid was treated in a centrifuge at 1500 rpm for 4 minutes to eliminate coarse particles, and thus an inkjet ink (ink for printing processes) was obtained.

The dynamic viscosity of the inkjet ink thus prepared was measured with a small-sized vibration viscometer SV-10 manufactured by A&D Co., Ltd., and the viscosity was 8 mPa·s. The surface tension of the same inkjet ink was measured with a fully automated surface tensiometer CBVP-Z manufactured by Kyowa Interface Science Co., Ltd., and the surface tnesion was 45 mN/m.

(Evaluation of dispersibility and dispersion stability)

One day after the preparation of the ink, the particle size distribution was measured using a laser scattering type particle size distribution analyzer (Beckman-Coulter, Inc., LS13 320). Thereafter, 10 ml of the ink was taken in a 10-ml capped test tube, and the test tube was tightly stopped and then was left to stand in a vertical position. The occurrence of precipitation and the presence or absence of supernatant after one week were evaluated by visual inspection.

As a result, the particle size distribution exhibited a particle size distribution with a volume average particle size of 0.07 $\mu$m and $d_{90\%}$ (90% particle size): 0.2 $\mu$m, and the dispersibility was satisfactory without any coarse particles having a size of 1 $\mu$m or larger. The ink that was left to stand did not show any precipitate or supernatant after one week, and had satisfactory dispersion stability.

(Quantitative analysis of ionic impurities of copper oxide nanoparticles)

3.5 g of copper oxide nanoparticles (average primary particle size 74 nm, manufactured by C.I. Kasei Co., Ltd.) was added to 35 mL of ultrapure water, the mixture was sealed in a container made of Teflon (registered trademark), and then ionic components were extracted for 24 hours at 120°C. The extract liquid was filtered through a 0.2-$\mu$m or 0.02-$\mu$m filter, and then the filtrate was analyzed by cation and anion chromatography. The detected peaks were calibrated using standard solutions, and thus the respective amounts of ionic extract were quantitatively determined.

The results of the measurement are summarized in Table 1. The total amount of ionic impurities was 1510 ppm.

(Quantitative analysis of ionic impurities in inkjet ink)

The inkjet ink thus prepared was heated in a Teflon (registered trademark) flask to remove the dispersion medium, and the residue was dried in a vacuum. Subsequently, the dried product was analyzed in the same manner as in the Section "Quantitative analysis of ionic impurities of copper oxide nanoparticles", and thus ionic impurities were quantitatively determined. As a result, the total amount of ionic impurities contained in the inkjet ink was 1920 ppm.

(Inkjet discharge test)

The inkjet ink was discharged with an inkjet apparatus (MJP Printer, manufactured by Microjet Technology Co., Ltd.) through continuous discharge for 5 minutes and intermittent discharge at an interval of 3 minutes, in a discharge amount of 90 ng/droplet. In all cases, satisfactory discharge without clogging of the nozzle or abnormality in the discharged liquid droplets was confirmed.

(Inkjet printing test)

Printing of a comb-like pattern was carried out on a glass substrate using the inkjet ink with an inkjet apparatus (MJP Printer, manufactured by Microjet Technology Co., Ltd.), and satisfactory printing properties were confirmed at a line width of 110 $\mu$m. The relevant printed pattern is shown in the drawing-substitute photograph of FIG. 1.

[Example 2]

(Preparation of inkjet ink)

An inkjet ink was prepared in the same manner as in Example 1, except that NMP (N-methylpyrrolidone) was used as the dispersion medium instead of $\gamma$-butyrolactone. Subsequently, an analysis of the total amount of ionic impurities was carried out in the same manner as in the Section "Quantitative analysis of ionic impurities" of Example 1. The analysis results are presented in Table 1.

(Dispersion stability)

In the same manner as in the Section "Evaluation of dispersibility and dispersion stability" of Example 1, the particle size distribution after one day, and the occurrence of precipitation and the presence or absence of supernatant after one week were evaluated. As a result, the particle size distribution exhibited a monomodal particle size distribution with a volume average particle size of 0.07 $\mu$m and $d_{90\%}$: 0.1 $\mu$m, and the dispersibility was satisfactory. The ink that had been left to stand did not show any precipitate or supernatant after one week, and the dispersion stability was satisfactory.

(Inkjet printing test)

An inkjet discharge test was carried out in the same manner as in the Section "Inkjet printing test" of Example 1. Satisfactory discharge without clogging of nozzles or abnormality of discharged liquid droplets was confirmed.

[Example 3]

(Preparation of inkjet ink)

10 g of copper nanoparticles (average particle size 76 nm, manufactured by Nissei Engineering, Inc.) having a core/shell structure in which the core part is made of copper and the shell part is made of copper oxides, and 40 g of $\gamma$-butyrolactone were weighed in a sample bottle, and then the bottle was tightly stopped. The mixture was treated with an ultrasonic cleaner for 60 minutes, and thus an inkjet ink was obtained.

(Dispersion stability)

In the same manner as in the Section "Evaluation of dispersibility and dispersion stability" of Example 1, the particle size distribution after one day, and the occurrence of precipitation and the presence or absence of supernatant after one week were evaluated.
As a result, the particle size distribution exhibited a bimodal particle size distribution with a volume average particle size of 0.2 $\mu$m and $d_{90\%}$: 0.6 $\mu$m, which included a small amount of aggregates, and the dispersibility was satisfactory without coarse particles having a size of 1 $\mu$m or larger. The ink that had been left to stand did not show any precipitate or supernatant after one week, and the dispersion stability was satisfactory.

(Quantitative analysis of ionic impurities)

Ionic impurities were quantitatively determined in the same manner as in Example 1. The results are summarized in Table 1. The total amount of ionic impurities was 473 ppm.

[Example 4]

(Preparation of inkjet ink)

An inkjet ink was prepared in the same manner as in Example 3, except that NMP was used as the dispersion medium instead of γ-butyrolactone.

(Dispersion stability)

The occurrence of precipitation and the presence or absence of supernatant after one week were evaluated in the same manner as in the Section "Evaluation of dispersibility and dispersion stability" of Example 1. As a result, the ink that had been left to stand did not show precipitate or supernatant after one week, and the dispersion stability was satisfactory.

[Comparative Example 1]

(Preparation of inkjet ink)

20 g of copper nanoparticles (copper, but natural oxides, average primary particle size 100 nm, manufactured by TEKNA Plasma Systems, Inc.) and 80 g of γ-butyrolactone were weighed, and the mixture was treated according to the Section "Preparation of inkjet ink" of Example 1. Thus, an inkjet ink was obtained.

(Dispersion stability)

The particle size distribution after one day, and the occurrence of precipitation and the presence or absence of supernatant after one week were evaluated in the same manner as in the Section "Evaluation of dispersibility and dispersion stability" of Example 1.
As a result, the particle size distribution exhibited a monomodal particle size distribution with a volume average particle size of 0.3 $\mu$m and $d_{90\%}$: 0.4 $\mu$m, and the dispersibility was satisfactory. However, the ink that had been left to stand showed a large amount of precipitate and supernatant after one week, and the dispersion stability was poor.

(Ion quantitative analysis)

Ionic impurities were quantitatively determined in the same manner as in Example 1. The results are summarized in Table 1. The total amount of ionic impurities was 2610 ppm.

[Comparative Example 2]

(Preparation of inkjet ink)

An inkjet ink was prepared in the same manner as in Comparative Example 1, except that NMP was used as the dispersion medium instead of γ-butyrolactone.

(Dispersion stability)

The particle size distribution after one day, and the occurrence of precipitate and the presence or absence of supernatant after one week were evaluated in the same manner as in the Section "Evaluation of dispersibility and dispersion stability" of Example 1.
As a result, the particle size distribution exhibited a monomodal particle size distribution with a volume average particle size of 0.3 $\mu$m and $d_{90\%}$: 0.4 $\mu$m, and the dispersibility was satisfactory. However, the ink that had been left to stand showed the occurrence of a large amount precipitate after one week, and the dispersion stability was poor.

[Comparative Example 3]

(Preparation of inkjet ink)

20 g of copper oxide nanoparticles (cupric oxide, average primary particle size 7.9 nm, manufactured by Nano-Size, Ltd.) was mixed with 80 g of γ-butyrolactone (particle concentration 20 mass%), and the mixture was treated in the same manner as in the Section "Preparation of inkjet ink" of Example 1. Thus, an inkjet ink was obtained.

(Dispersion stability)

The inkjet ink thus prepared was evaluated in the same manner as in the Section "Evaluation of dispersibility and dispersion stability" of Example 1. As a result, the particle size distribution exhibited a particle size distribution with a volume average particle size of 0.9 $\mu$m and $d_{90}$: 1.5 $\mu$m, and included aggregates having a size of 1 $\mu$m or larger. Thus, the dispersibility was poor. The inkjet ink that had been left to stand showed the occurrence of supernatant after one week, and the dispersion stability was poor.

(Quantitative analysis of ionic impurities)

Ionic impurities were quantitatively determined in the same manner as in Example 1. The results are summarized in Table 1. The total amount of ionic impurities was 170,000 ppm.

[Comparative Example 4]

(Preparation of inkjet ink)

An inkjet ink was prepared in the same manner as in Example 3, except that N-methylpyrrolidone was used as the dispersion medium.

(Dispersion stability)

The inkjet ink thus prepared was evaluated in the same manner as in the Section "Evaluation of dispersibility and dispersion stability" of Example 1. As a result, the particle size distribution had a volume average particle size of 5.6 $\mu$m and $d_{90}$: 14.57 $\mu$m, and the dispersibility was poor. The inkjet ink that had been left to stand showed the occurrence of supernatant after one week, and the dispersion stability was poor.

[Comparative Example 5]

(Preparation of inkjet ink)

20 g copper oxide nanoparticles (average primary particle size 41 nm, manufactured by Nissei Engineering, Inc.) was mixed with 80 g of $\gamma$-butyrolactone (particle concentration 20 mass%), and the mixture was treated in the same manner as in the Section "Preparation of inkjet ink" of Example 1. Thus, an inkjet ink was obtained.

(Dispersion stability)

The inkjet ink thus prepared was evaluated in the same manner as in the Section "Evaluation of dispersibility and dispersion stability" of Example 1. As a result, the particle size distribution exhibited a particle size distribution with a volume average particle size of 15 $\mu$m and $d_{90}$: 47 $\mu$m, which included a peak of aggregates, and the dispersibility was poor. Furthermore, the inkjet ink that had been left to stand showed the occurrence of supernatant after one week, and the dispersion stability was poor.

(Quantitative analysis of ionic impurities)

Ionic impurities were quantitatively determined in the same manner as in Example 1. The results are presented in Table 1. The total amount of ionic impurities was 10800 ppm.

[Comparative Example 6]

(Preparation of inkjet ink)

An inkjet ink was prepared in the same manner as in Comparative Example 5, except that N-methylpyrrolidone was used as the dispersion medium.

(Dispersion stability)

The inkjet ink thus prepared was evaluated in the same manner as in the Section "Evaluation of dispersibility and dispersion stability" of Example 1. As a result, the particle size distribution exhibited a volume average particle size of 6 $\mu$m and $d_{90}$: 18 $\mu$m. The inkjet ink that had been left to stand showed the occurrence of supernatant after one week, and the dispersion stability was poor.

As discussed above, an investigation was conducted on various Cu-based nanoparticles, and as a result, when Cu-based nanoparticles having a small amount of ionic impurities were used, satisfactory dispersibility and dispersion stability were obtained. In addition, while the amount of ionic impurities of the Cu-based nanoparticles used in the inkjet ink of Example 1 was 1510 ppm, while the total amount of ionic impurities contained in the relevant inkjet ink was 1920 ppm. That is, during the preparation of the inkjet ink, the amount of ionic impurities increased by 410 ppm compared with the raw material Cu-based nanoparticles, and it is speculated that this increment has been incorporated from the dispersion medium, the dispersing apparatus or the container. However, it is understood that the amount of impurities is very small as compared with the amount of ionic impurities contained in the various Cu-based nanoparticles themselves. It is thought that this fact applies even in the case where an inkjet ink is prepared using other Cu-based nanoparticles. Therefore, evaluating and reducing the ionic impurities contained in the raw material Cu-based nanoparticles is effective in the evaluation of dispersion stability and an enhancement of stability.

[Table 1]

| | Dispersion liquid | | Extracted ion (ppm) | | | | | | | | | | | | | | |
|---|---|---|---|---|---|---|---|---|---|---|---|---|---|---|---|---|---|
| | Dispersion medium | Dispersibility | $F^-$ | $(COO)_2^{2-}$ | $CH_3COO^-$ | $HCOO^-$ | $Cl^-$ | $NO_2^-$ | $Br^-$ | $NO_3^-$ | $PO_4^{3-}$ | $SO_4^{2-}$ | $NH_4^+$ | $Na^+$ | $K^+$ | $Li^+$ | Total |
| Example 1 | GBL | ◎ | 40 | 350 | 0 | 150 | 0 | 0 | 0 | 610 | 0 | 0 | 350 | 420 | 0 | 0 | 1920 |
| Example 2 | NMP | ◎ | | | | | | | | | | | | | | | |
| Example 3 | GBL | ○ | 0 | 0 | 55 | 4 | 4 | 0 | 0 | 0 | 150 | 0 | 260 | 0 | 0 | 0 | 473 |
| Example 4 | NMP | ○ | | | | | | | | | | | | | | | |
| Comparative Example 1 | GBL | × | 32 | 0 | 0 | 70 | 1300 | 0 | 0 | 4 | 0 | 1200 | 0 | 6 | 0 | 0 | 2610 |
| Comparative Example 2 | NMP | △ | | | | | | | | | | | | | | | |
| Comparative Example 3 | GBL | × | 0 | 0 | 223 | 31 | 170000 | 0 | 0 | 0 | 0 | 0 | 0 | 0 | 0 | 0 | 170000 |
| Comparative Example 4 | NMP | × | | | | | | | | | | | | | | | |
| Comparative Example 5 | GBL | × | 3 | 0 | 18 | 2 | 30 | 525 | 0 | 7900 | 0 | 0 | 461 | 1900 | 0 | 0 | 10800 |
| Comparative Example 6 | NMP | × | | | | | | | | | | | | | | | |

The evaluation of dispersibility was carried out by observing the precipitation state after standing for 7 days, and performing an evaluation according to the following evaluation criteria.

(Evaluation criteria)

◎: The liquid is uniformly dispersed, and almost no precipitation occurs.
○: The liquid is substantially dispersed, and a small amount of precipitate occurs.
Δ: There is no transparent supernatant, but a large amount of precipitate occurs.
× : The supernatant is transparent, and the liquid is hardly dispersed.

In Table 1, GBL stands for γ-butyrolactone, and NMP stands for N-methylpyrrolidone. The same applies to Table 2 and Table 3 as well.

[Comparative Example 7]

(Preparation of inkjet ink)

27 g of copper oxide nanoparticles (cupric oxide, average particle size 74 nm, product name: Nanotek CuO®, manufactured by C.I. Kasei Co., Ltd.), 2.7 mg of sodium chloride (manufactured by Wako Pure Chemical Industries, Ltd.) corresponding to 100 ppm with respect to the copper oxide nanoparticles, and 73 g of γ-butyrolactone (copper oxide nanoparticle concentration 27 mass%) were weighed in a sample bottle, and an inkjet ink was prepared in the same manner as in Example 3.

(Dispersion stability)

The inkjet ink thus prepared was sealed in a 10-ml capped test tube, and the test tube was left to stand in a vertical position. The occurrence of precipitation and the presence or absence of supernatant after one week were evaluated. As a result, a supernatant occurred, and the dispersion stability was poor.

(Quantitative analysis of ionic impurities)

A powder prepared by adding, to copper oxide nanoparticles, sodium chloride in an amount of 1000 ppm with respect to the copper oxide nanoparticles, was quantitatively determined in the same manner as in Example 1. The results are presented in Table 1. The total amount of ionic impurities was 2710 ppm.

[Comparative Example 8]

(Preparation of inkjet ink)

An inkjet ink was prepared in the same manner as in Comparative Example 7, except that N-methylpyrrolidone (copper oxide nanoparticle concentration 27 mass%) was used as the dispersion medium.

(Dispersion stability)

The inkjet ink thus prepared was evaluated in the same manner as in the Section "Evaluation of dispersibility and dispersion stability" of Comparative Example 7. As a result, a large amount of precipitate occurred, and dispersion stability was poor.

As such, when ionic sodium chloride is added in an amount of 1000 ppm to an inkjet ink having high dispersibility and high dispersion stability, the dispersibility and dispersion stability deteriorated. It is understood that the ionic impurities in the inkjet ink deteriorate dispersibility and dispersion stability.

[Table 2]

| | Dispersion liquid | | Amount of extracted ion (ppm) | | | | | | | | | | | | | | |
| --- | --- | --- | --- | --- | --- | --- | --- | --- | --- | --- | --- | --- | --- | --- | --- | --- | --- |
| | Solvent | Dispersibility | $F^-$ | $(COO)_2^{2-}$ | $CH_3COO^-$ | $HCOO^-$ | $Cl^-$ | $NO_2^-$ | $Br^-$ | $NO_3^-$ | $PO_4^{3-}$ | $SO_4^{2-}$ | $NH_4^+$ | $Na^+$ | $K^+$ | $Li^+$ | Total |
| Example 1 | GBL | ◎ | 40 | 350 | 0 | 150 | 0 | 0 | 0 | 610 | 0 | 0 | 350 | 420 | 0 | 0 | 1920 |
| Example 2 | NMP | ◎ | | | | | | | | | | | | | | | |
| Example 3 | GBL | ○ | 0 | 0 | 55 | 4 | 4 | 0 | 0 | 0 | 150 | 0 | 260 | 0 | 0 | 0 | 473 |
| Example 4 | NMP | ○ | | | | | | | | | | | | | | | |
| Comparative Example 7 | GBL | × | 0 | 0 | 6 | 2 | 280 | 0 | 0 | 2000 | 0 | 0 | 0 | 420 | 0 | 0 | 2710 |
| Comparative Example 7 | NMP | △ | | | | | | | | | | | | | | | |

The evaluation of dispersibility was carried out by observing the precipitation state after standing for 7 days, and performing an evaluation according to the following evaluation criteria.

(Evaluation criteria)

◎: The liquid is uniformly dispersed, and almost no precipitation occurs.
○: The liquid is substantially dispersed, and a small amount of precipitate occurs.
Δ: There is no transparent supernatant, but a large amount of precipitate occurs.
× : The supernatant is transparent, and the liquid is hardly dispersed.

[Example 5]

(Preparation of inkjet ink)

10 g of the copper oxide nanoparticles used in Comparative Example 5 were suspended in 200 g of ultrapure water, and then the suspension was sealed in a bag of dialysis membrane. The bag of dialysis membrane containing the suspension was immersed in ultrapure water, the electrical conductivity of the ultrapure water was measured after 24 hours, and then the ultrapure water was exchanged. Dialysis was carried out. After a lapse of one month, the electrical conductivity became constant, and thus dialysis was completed. The water in the suspension was removed by centrifugation (15,000 rpm × 40 min), and the residue was dried in a reduced pressure dryer for 24 hours. Thus, copper oxide nanoparticles from which ionic impurities had been eliminated were obtained.

0.3 g of the copper oxide nanoparticles from which ionic impurities had been eliminated, and 5 g ofN-methylpyrrolidone were weighed, and the resulting mixture was treated for 30 minutes in a bead mill (800 rpm × 30 min). Thus, an inkjet ink was obtained.

(Dispersion stability)

The particle size distribution after one day, and the occurrence of precipitation and the presence or absence of supernatant after one week were evaluated in the same manner as in the Section "Evaluation of dispersibility and dispersion stability" of Example 1.

[Ion quantitative analysis]

The copper oxide nanoparticles from which ionic impurities had been eliminated were used to quantitatively determine the ionic impurities in the same manner as in Example 1. The results are summarized in Table 1. The total amount of ionic impurities was 255 ppm.

As such, it is understood that when ionic impurities are removed from Cu-based particles having poor dispersibility and dispersion stability (Comparative Example 5), and then the particles are dispersed, dispersibility and dispersion stability are enhanced.

[Table 3]

| | Inkjet ink | | Amount of extracted ion (ppm) | | | | | | | | | | | | | |
| | Dispersion medium | Dispersibility | $F^-$ | $(COO)_2^{2-}$ | $CH_3COO^-$ | $HCOO^-$ | $Cl^-$ | $NO_2^-$ | $Br^-$ | $NO_3^-$ | $PO_4^{3-}$ | $SO_4^{2-}$ | $NH_4^+$ | $Na^+$ | $K^+$ | $Li^+$ | Total |
|---|---|---|---|---|---|---|---|---|---|---|---|---|---|---|---|---|---|
| Example 5 | GBL | ○ | 1 | 0 | 0 | 0 | 7 | 164 | 0 | 76 | 0 | 0 | 6 | 0 | 0 | 0 | 255 |
| Comparative Example 6 | GBL | × | 3 | 0 | 18 | 2 | 30 | 525 | 0 | 7900 | 0 | 0 | 461 | 1900 | 0 | 0 | 10800 |

EP 2 479 227 B1

23

The evaluation of dispersibility was carried out by observing the precipitation state after standing for 7 days, and performing an evaluation according to the following evaluation criteria.

(Evaluation criteria)

◎: The liquid is uniformly dispersed, and almost no precipitation occurs.
○: The liquid is substantially dispersed, and a small amount of precipitate occurs.
Δ: There is no transparent supernatant, but a large amount of precipitate occurs.
X: The supernatant is transparent, and the liquid is hardly dispersed.

[Example 6]

(Preparation of ink for printing processes (metal nanoparticle dispersion liquid))

27 g of copper oxide nanoparticles (cupric oxide, average particle size 74 nm, product name: Nanotek CuO®, manufactured by C.I. Kasei Co., Ltd.) was added to 73 g of γ-butyrolactone (GBL) (copper oxide nanoparticle concentration: 27 mass%), and the mixture was treated with an ultrasonic homogenizer (US-600, manufactured by Nippon Seiki Co., Ltd.) at 19.6 kHz and 600 W for 5 minutes. This dispersion liquid was treated in a centrifuge at 1500 rpm for 5 minutes to eliminate coarse particles, and thus an ink for printing processes (metal nanoparticle dispersion liquid) for an inkjet system was prepared.
The dynamic viscosity (measured with a small-sized vibration viscometer SV-10, manufactured by A&D Co. Ltd.) of the ink (metal nanoparticle dispersion liquid) thus prepared was 8 mPa·s, and the surface tension (measured with a fully automated surface tensiometer CBVP-Z, manufactured by Kyowa Interface Science Co., Ltd.) was 45 mN/m.

(Evaluation of dispersibility and dispersion stability)

After the preparation of the ink (metal nanoparticle dispersion liquid) for printing processes, the particle size distribution was analyzed using a laser scattering type particle size distribution analyzer (manufactured by Beckman-Coulter, Inc., LS13 320). Thereafter, 10 ml of the ink was taken in a 10-ml capped test tube, and the test tube was tightly stopped and was left to stand in a vertical position. The occurrence of precipitation and the presence or absence of supernatant after one week were evaluated by visual inspection.
As a result, the particle size distribution exhibited a particle size distribution with an average particle size of 0.07 μm, without any coarse particles having a size of 1 μm or larger, and the dispersibility was satisfactory. The ink that had been left to stand did not show any precipitate or supernatant after one week, and the dispersion stability was satisfactory.

(Measurement of zeta potential)

1.0 mg of copper oxide nanoparticles (average particle size 74 nm, manufactured by C.I. Kasei Co., Ltd.) was added to 100 mL of GBL, the container was sealed, and then the mixture was treated with an ultrasonic cleaner for 20 minutes. This dispersion liquid (ink) was equilibrated for 24 hours, and then the zeta potential was measured using a zeta potential analyzer (manufactured by Beckman-Coulter, Inc., Delsa 440SX). The measurement results are summarized in Table 4.

(Quantitative analysis of ionic impurities)

3.5 g of copper oxide nanoparticles (average particle size 74 nm, manufactured by C.I. Kasei Co., Ltd.) was added to 35 mL of ultrapure water, the mixture was sealed in a container made of a fluororesin, and then ionic components were extracted at 120°C for 24 hours. The extract liquid was filtered through a 0.2-μm or 0.02-μm filter, and then was analyzed by cation and anion chromatography. The detected peaks were calibrated using standard solutions, and thus the amounts of various ionic extracts were quantitatively determined. The measurement results are summarized in Table 4.

(Inkjet discharge test)

The ink for printing processes was discharged with an inkjet apparatus (MJP Printer, manufactured by Microjet Technology Co., Ltd.) through continuous discharge for 5 minutes and intermittent discharge at an interval of 3 minutes, in a discharge amount of 90 ng/droplet. In all cases, satisfactory discharge without clogging of the nozzle or abnormality in the discharged liquid droplets was confirmed.

(Inkjet printing test)

Printing of a comb-like pattern was carried out on a glass substrate using the ink for printing processes with an inkjet apparatus (MJP Printer, manufactured by Microjet Technology Co., Ltd.), and satisfactory printing properties were confirmed at a line width of 110 $\mu$m (see FIG. 1; the unit indicated in the diagram is $\mu$m).

[Example 7]

(Preparation of ink for printing processes)

An ink for printing processes was prepared in the same manner as in Example 6, except that N-methylpyrrolidone (NMP) was used as the dispersion medium instead of GBL.
The dynamic viscosity (measured with a small-sized vibration viscometer SV-10, manufactured by A&D Co. Ltd.) of the ink for printing processes thus prepared was 4.7 mPa·s, and the surface tension (measured with a fully automated surface tensiometer CBVP-Z, manufactured by Kyowa Interface Science Co., Ltd.) was 40 mN/m.

(Dispersion stability)

In the same manner as in Example 6 (evaluation of dispersibility and dispersion stability), the particle size distribution after one day, and the occurrence of precipitation and the presence or absence of supernatant after one week were evaluated. As a result, the particle size distribution exhibited a monomodal particle size distribution with an average particle size of 0.07 $\mu$m, and the dispersibility was satisfactory. The ink that had been left to stand did not show any precipitate or supernatant after one week, and the dispersion stability was satisfactory.

(Ion quantitative analysis)

Ionic impurities were quantitatively determined in the same manner as in Example 6. The results are summarized in Table 4. The total amount of ionic impurities was 1500 ppm.

(Measurement of zeta potential)

The zeta potential of the dispersion liquid was measured in the same manner as in Example 6, except that NMP was used as the dispersion medium instead of GBL. The measurement results are presented in Table 4.

(Inkjet printing test)

An inkjet discharge test was carried out in the same manner as in Example 6, and satisfactory discharge without clogging of nozzles or abnormality in the discharged liquid droplets was confirmed.

[Example 8]

(Preparation of ink for printing processes)

An ink for printing processes was prepared in the same manner as in Example 6, except that ionic impurities-reduced surface copper oxide nanoparticles (average particle size 100 nm, manufactured by TEKNA Plasma Systems, Inc.) were used instead of the copper oxide nanoparticles, and propylene carbonate was used as the dispersion medium instead of GBL.
The dynamic viscosity (measured using a viscoelasticity analyzer MCR501 equipped with a measurement jig CP50-1, manufactured by Nihon SiberHegner K.K.) of the ink for printing processes thus prepared was 30.0 mPa·s.

(Dispersion stability)

In the same manner as in Example 6 (evaluation of dispersibility and dispersion stability), the particle size distribution after one day, and the occurrence of precipitation and the presence or absence of supernatant after one week were evaluated. As a result, the particle size distribution exhibited a bimodal particle size distribution with average particle sizes of 0.1 μm and 1 μm, and the 90% dispersion particle size was 400 nm. The ink that had been left to stand did not show any precipitate or supernatant after one week, and the dispersion stability was satisfactory.

(Ion quantitative analysis)

Ionic impurities were quantitatively determined in the same manner as in Example 6. The results are summarized in Table 4. The total amount of ionic impurities was 830 ppm.

(Measurement of zeta potential)

The zeta potential of the dispersion liquid was measured in the same manner as in Example 6, except that propylene carbonate was used as the dispersion medium instead of GBL. The zeta potential was -31 mV.

[Comparative Example 9]

(Preparation of ink for printing processes)

An ink for printing processes was obtained by treating in the same manner as in Example 6, except that 20 g of copper nanoparticles (average particle size 100 nm, manufactured by TEKNA Plasma Systems, Inc.) were used, and NMP was used as the dispersion medium.

(Dispersion stability)

In the same manner as in Example 6, the particle size distribution after one day, and the occurrence of precipitation and the presence or absence of supernatant after one week were evaluated.
As a result, the particle size distribution exhibited a particle size distribution with an average particle size of 0.3 μm, and the dispersibility was satisfactory. However, the ink for printing processes that had been left to stand exhibited a large amount of precipitate and supernatant after one week, and the dispersion stability was poor.

(Ion quantitative analysis)

Ionic impurities were quantitatively determined in the same manner as in Example 6.
The results are summarized in Table 4. The total amount of ionic impurities was 2600 ppm.

(Measurement of zeta potential)

The zeta potential of the dispersion liquid was measured in the same manner as in Example 6, except that NMP was used as the dispersion medium instead of GBL. The zeta potential was -25 mV.

(Inkjet printing test)

Since the ink contained a large amount of precipitate, and there was a possibility of causing clogging in the nozzle and the head of the inkjet printing apparatus, the inkjet printing test was not carried out.

[Comparative Example 10]

(Preparation of dispersion liquid)

A dispersion liquid was prepared in the same manner as in Example 6, except that 20 g of copper oxide nanoparticles (average particle size 41 nm, manufactured by Nissei Engineering, Inc.) were used, and 80 g of NMP was used as the dispersion medium.

(Dispersion stability)

In the same manner as in Example 6, the particle size distribution after one day, and the occurrence of precipitate and the presence or absence of supernatant after one week were evaluated.
As a result, the particle size distribution exhibited a particle size distribution with an average particle size of 6

μm. The ink that had been left to stand showed a large amount of precipitate and supernatant after one week, and the dispersion stability was poor.

(Ion quantitative analysis)

Ionic impurities were quantitatively determined in the same manner as in Example 6. The results are summarized in Table 4. The total amount of ionic impurities was 11000 ppm.

(Measurement of zeta potential)

The zeta potential of the dispersion liquid was measured in the same manner as in Example 6, except that NMP was used as the dispersion medium instead of GBL. The zeta potential was -16 mV.

(Inkjet printing test)

Since the ink contained a large amount of precipitate, and there was a possibility of causing clogging in the nozzle and the head of the inkjet printing apparatus, the inkjet printing test was not carried out.

[Comparative Example 11]

(Preparation of ink for minute printing processes)

An ink for printing processes was prepared in the same manner as in Example 6, except that 5 g of copper nanoparticles (copper, but natural oxides, average particle size 100 nm, manufactured by TEKNA Plasma Systems, Inc.) and 20 g of GBL were used.

(Dispersion stability)

In the same manner as in Example 6, the particle size distribution after one day, and the occurrence of precipitate and the presence or absence of supernatant after one week were evaluated.
As a result, the particle size distribution exhibited a particle size distribution with an average particle size of 0.1 μm, without coarse particles having a size of 1 μm or larger, and dispersibility was satisfactory. The ink that had been left to stand showed a large amount of precipitate after one week, and the dispersion stability was poor.

(Quantitative analysis of ionic impurities)

The amount of ionic impurities was quantitatively determined by using ion chromatography in the same manner as in Example 6. The results are presented in Table 4.

(Measurement of zeta potential)

The zeta potential of the dispersion liquid was measured in the same manner as in Example 6. The zeta potential was -57 mV.

(Inkjet printing test)

Since the ink contained a large amount of precipitate, and there was a possibility of causing clogging in the nozzle and the head of the inkjet printing apparatus, the inkjet printing test was not carried out.
As discussed above, an investigation was conducted on various Cu-based nanoparticles, and as a result, when the amount of ionic impurities was small, and the absolute value of the zeta potential was large, satisfactory dispersion stability was obtained.

[Table 4]

| Item | Amount of ionic impurities ppm | Zeta potential mV | Dispersion stability |
|---|---|---|---|
| Example 6 | 1500 | -47 | Good |
| Example 7 | 1500 | -66 | Good |

(continued)

| Item | Amount of ionic impurities ppm | Zeta potential mV | Dispersion stability |
|---|---|---|---|
| Example 8 | 830 | -31 | Good |
| Comparative Example 9 | 2600 | -25 | Poor |
| Comparative Example 10 | 11000 | -16 | Poor |
| Comparative Example 11 | 3300 | -57 | Poor |

As can be seen from Table 4, Example 6 and Example 7 exhibited an absolute value of the zeta potential of 30 mV or higher, and an amount of ionic impurities of 2600 ppm or less, and they had satisfactory dispersion stability.

On the other hand, Comparative Example 9 had an amount of ionic impurities of 2600 ppm or less, but since the absolute value of the zeta potential was smaller than 30 mV, the dispersion stability was poor.

Comparative Example 10 had an amount of ionic impurities of greater than 2600 ppm, and an absolute value of the zeta potential of smaller than 30 mV, and therefore, the dispersion stability was poor.

Comparative Example 11 had an absolute value of the zeta potential of 30 mV or higher, but since the amount of ionic impurities exceeded 2600 ppm, the dispersion stability was poor.

[Examples 8 and 9]

(Formation of wiring pattern and conductorization)

A wiring pattern (line width 110 $\mu$m, and thickness 1 $\mu$m) was formed on a glass substrate using the ink for printing processes (metal nanoparticle dispersion liquid) of Example 6 or Example 7 with an inkjet apparatus (MJP printer, manufactured by Microjet Technology Co., Ltd.). The wiring pattern was heated at 180°C for 30 minutes under a reducing gas (formic acid) atmosphere, and was subjected to a reduction treatment. Thus, the wiring pattern was conductorized.

The conductorized wiring pattern was measured with a digital multitester CDM-11D manufactured by Custom Co., Ltd. As a result, the volume resistivity calculated from the wiring resistance was such that when the ink for printing processes (metal nanoparticle dispersion liquid) of Example 1 was used, the volume resistivity was $3 \times 10^{-8}$ $\Omega$·m, and when the ink for printing processes (metal nanoparticle dispersion liquid) of Example 2 was used, the volume resistivity was $4 \times 10^{-8}$ $\Omega$·m.

[Examples 10 to 16 and Comparative Examples 12 to 17]

(Preparation of ink for printing processes)

The metal nanoparticles were mixed with the dispersion medium in each of the Examples and Comparative Examples. The types of the dispersion medium are presented in Table 5. The types of metal nanoparticles and blending amounts of the metal nanoparticles and the dispersion medium each mixture are presented in Table 6. The mixture was treated for 5 minutes with an ultrasonic homogenizer US-600 CCVP manufactured by Nippon Seiki Co., Ltd. at an output power of 600 W, a vibration frequency of 19.5 kHz, and an amplitude value of 26.5 $\mu$m, and 35 g of the mixture was weighed in a 50-ml centrifugal precipitation tube. The mixture was subjected to a centrifugal treatment at 1500 rpm for 4 minutes, and the supernatant was used as the ink for printing processes. For the metal nanoparticles, Cu1 (NanoTek CuO®, manufactured by CIK Nanotek Corp., specific surface area 12 m$^2$/g, primary particle size 75 nm, copper oxide), and Cu2 (CuO-MIX40, manufactured by NanoSize, Ltd., specific surface area 130 m$^2$/g, primary particle size 10 nm, copper oxide) were used.

(Evaluation method for dispersibility)

Meanwhile, for the evaluation of dispersibility, first, each metal nanoparticle dispersion liquid prior to the centrifugal treatment was left to stand for 30 minutes, and the presence or absence of precipitation was evaluated by visual inspection. Those having satisfactory dispersibility without the occurrence of precipitation were subjected to a centrifugal treatment, and then the particle size distribution analysis was carried out with a laser diffraction scattering particle size distribution analyzer (Beckman-Coulter, Inc., LS 13 320).

Dispersibility was evaluated according to the following evaluation criteria. The results are presented in Table 7.

(L/D value)

The volume of the metal nanoparticles in the ink for printing processes thus prepared, and the volume of the ink for printing processes were respectively calculated by dividing the mass by the density, and the F value was determined. Furthermore, L (nm) was determined by the following formula, and the value of L/D was determined. The results are presented in Table 7.

$$L\ (nm) = D/2 + Ls\ (nm)$$

$$Ls\ (nm) = D \times [(1/3 \times \pi \times F + 5/6)^{0.5} - 1]$$

F = Volume of metal nanoparticles in ink for printing processes/volume of ink for printing processes

(Evaluation criteria for dispersibility)

◎: The average particle size was less than 300 nm, and the maximum particle size was less than 800 nm.
○: The average particle size was 300 nm to 800 nm, and the maximum particle size was 800 nm to 2000 nm.
△: After standing for 30 minutes, no precipitation occurred.
×: After standing fro 30 minutes, precipitation occurred.

(Evaluation of conductivity)

The ink for printing processes thus obtained was applied on a slide glass using an applicator with a gap of 150 μm, and the ink was dried on a hot plate at 60°C for 30 minutes in a nitrogen atmosphere. Thus, a coated substrate was obtained. The coated substrate was mounted on a hot wire type atomic hydrogen treatment apparatus having the same structure as shown in FIG. 2, and a reduction treatment was carried out for 20 minutes under the conditions of hydrogen at 0.118 Pa·m$^3$/s, a tungsten wire temperature of 1800°C, a pressure of 5.3 Pa, and a stage temperature (temperature of substrate holding unit) of 44°C. An electric current was passed through the tungsten wire, and hydrogen was stopped. Subsequently, the system was cooled for 10 minutes, and then was returned to normal pressure. The ink for printing processes-coated substrate was taken out. The coated substrate which was black in color before the treatment changed to red copper color after the treatment (see FIG. 4). The coated substrate after the treatment was subjected to cutting work by means of an FIB (focused ion beam) apparatus, and the film thickness was measured by observing the cross-section by SIM (scanning ion image). The surface resistivity of the film was measured with a four-probe type microresistance analyzer (Loresta MCP-T610, manufactured by Mitsubishi Chemical Corp.), and the measured value of surface resistivity was converted to volume resistivity using the measured value of the film thickness. If the value was $10^{-5}$ Ω·m or less, the electrical conductivity was rated as ○, and if the value exceeded $10^{-5}$ Ω·m, the electrical conductivity was rated as ×. The results are presented in Table 7.

[Table 5]

| Dispersion medium | Name | CAS No. |
|---|---|---|
| Solv1 | Propylene carbonate | 108-32-7 |
| Solv2 | γ-Butyrolactone | 96-48-0 |
| Solv3 | Dimethyl sulfoxide | 67-68-5 |
| Solv4 | N-methylpyrrolidone | 872-50-4 |
| Solv5 | Isophorone | 78-59-1 |
| Solv6 | Dipropylene glycol monomethyl ether | 34590-94-8 |
| Solv7 | 2-Butoxyethyl acetate | 112-07-2 |
| Solv8 | Tetradecane | 629-59-4 |

[Table 6]

| | Copper nanoparticles | | Dispersion medium | |
|---|---|---|---|---|
| | Type | Mass (g) | Type | Mass (g) |
| Example 10 | Cu1 | 32.5 | Solv2 | 97.5 |
| Example 11 | Cu1 | 32.5 | Solv2 | 97.5 |
| Example 12 | Cu1 | 32.5 | Solv1 | 97.5 |
| Example 13 | Cu1 | 32.5 | Solv2 | 97.5 |
| Example 14 | Cu1 | 11 | Solv3 | 99 |
| Example 15 | Cu1 | 24 | Solv4 | 96 |
| Example 16 | Cu1 | 39 | Solv2 | 91 |
| Comparative Example 12 | Cu1 | 60 | Solv2 | 90 |
| Comparative Example 13 | Cu1 | 32.5 | Solv2 | 97.5 |
| Comparative Example 14 | Cu1 | 32.5 | Solv5 | 97.5 |
| Comparative Example 15 | Cu1 | 32.5 | Solv6 | 97.5 |
| Comparative Example 16 | Cu1 | 32.5 | Solv7 | 97.5 |
| Comparative Example 17 | Cu1 | 60 | Solv8 | 90 |

[Table 7]

| | L/D | Dispersion medium | Ink for printing processes | | Copper nanoparticle wiring | |
|---|---|---|---|---|---|---|
| | | Polar term in Hansen solubility parameter $(MPa^{0.5})$ | Dispersibility | Viscosity (mPa·s) | Reduction· sintering temperature (°C) | Electrical conductivity |
| Example 10 | 2.7 | 17 | ◎ | 2 | ≦ 280 | ○ |
| Example 11 | 2.0 | 17 | ◎ | 4 | ≦ 280 | ○ |
| Example 12 | 1.7 | 18 | ◎ | 5 | ≦ 280 | ○ |
| Example 13 | 1.7 | 17 | ◎ | 5 | ≦ 280 | ○ |
| Example 14 | 1.7 | 16 | ◎ | 5 | ≦ 280 | ○ |
| Example 15 | 1.7 | 12 | ◎ | 5 | ≦ 280 | ○ |
| Example 16 | 1.6 | 17 | ○ | 8 | ≦ 280 | ○ |
| Comparative Example 12 | 1.5 | 17 | Δ | 15 | ≦ 280 | ○ |
| Comparative Example 13 | 1.3 | 17 | × | ND | ≦ 280 | ○ |
| Comparative Example 14 | 1.7 | 8 | Δ | 10 | ≦ 280 | ○ |
| Comparative Example 15 | 1.7 | 7 | Δ | ND | ≦ 280 | ○ |
| Comparative Example 16 | 1.7 | 5 | Δ | ND | ≦ 280 | ○ |
| Comparative Example 17 | 1.7 | 0 | × | ND | ≦ 280 | ○ |

As shown in Table 7, the inks for printing processes of Examples 10 to 16, each of which satisfies the relation of $1.6 \leq L/D \leq 3.5$, uses a dispersion medium in which the polar term in the Hansen solubility parameter is 11 MPa$^{0.5}$ or greater, and is prepared without using a dispersant, all had excellent dispersibility. Furthermore, it was found that the wiring formed using these inks for printing processes did not have any problem in electrical conductivity even if electrical conductivity was imparted (reduction treatment) at a low temperature equal to or lower than 280°C (44°C).

<Carbon content>

For each of the Examples and Comparative Examples described above, in order to obtain the content of carbon atoms in the total solids content in the ink for printing processes, the carbon atoms of the copper oxide nanoparticles or the copper nanoparticles of each Example were measured by a high-frequency induction heating combustion-infrared absorption method (using EMIA-V series manufactured by Horiba, Ltd.).

[Examples 1, 2, 6, 7, 10 to 16, and Comparative Examples 12 to 17]

The carbon atom content of the copper oxide nanoparticles (cupric oxide, average primary particle size 74 nm, product name: Nanotek CuO®, manufactured by C.I. Kasei Co., Ltd.) used in these Examples and Comparative Examples was 0.15 mass%.

[Examples 3 and 4]

The carbon atom content of the copper nanoparticles having a core/shell structure in which the core part is made of copper and the shell part is made of copper oxides (average particle size 76 nm, manufactured by Nissei Engineering, Inc.) used in these Examples was 0.04 mass%.

[Example 8]

The carbon atom content of the ionic impurities-reduced surface copper oxide nanoparticles (average particle size 100 nm, manufactured b TEKNA Plasma Systems, Inc.) used in this Example was 0.38 mass%.

[Examples 10 to 16 and Comparative Examples 3, 4, 12 to 17]

The carbon atom content of the copper oxide nanoparticles (cupric oxide, average primary particle size 7.9 nm, NanoSize, Ltd.) used in these Examples and Comparative Examples were not known.

[Comparative Examples 1, 2 and 9]

The carbon atom content of the copper nanoparticles (copper, but natural oxides, average primary particle size 100 nm, manufactured by TEKNA Plasma Systems, Inc.) used in these Comparative Examples was 0.82 mass%.

[Comparative Examples 5, 6 and 11]

The carbon atom content of the copper oxide nanoparticles (average primary particle size 41 nm, manufactured by Nissei Engineering, Inc.) used in these Comparative Examples was 0.13 mass%.

From the above results, it can be considered that in the various Examples that do not use a dispersant or a protective agent, which serve as carbon sources, the carbon atom content is directly equivalent to the carbon atom content of the ink for printing processes. That is, the carbon content is 0.4 mass% or less.

REFERENCE SIGNS LIST

| 01 | Hot wire type atomic hydrogen treatment apparatus |
|---|---|
| 02 | Gas inlet port |
| 03 | Shower head |
| 04 | Exhaust port |
| 05 | Substrate holding unit |
| 06 | Temperature regulator |

07     Catalyst body
08     Shutter
09     Substrate
10, 11   Wiring
12     Metal nanoparticle
13     Substrate
14     Wiring
15     Electroless plated layer and/or electroplated layer

**Claims**

1. Producing process for an ink for printing processes, comprising a step to use at least metal nanoparticles, and to set up to have a carbon atom content in the total solids content of 0.4 mass% or less, the metal nanoparticles containing Cu and/or CuO and/or $Cu_2O$, and further comprising a step to set up the amount of ionic impurities to 2600 ppm or less in the total solids content, further comprising a step to set up the absolute value of the zeta potential to be 30 mV or greater.

2. The producing process for an ink for printing processes according to claim 1, wherein the amount of ionic impurities is set up to 1600 ppm or less in a dry powder of the metal nanoparticles, and the ink is prepared in a step of dispersing metal nanoparticles containing Cu and/or CuO and/or $Cu_2O$ in a dispersion medium.

3. The producing process for an ink for printing processes according to any one of claim 1 or 2, comprising a step to set up the 90% dispersion particle size of the metal nanoparticles containing Cu and/or CuO and/or $Cu_2O$ to be equal to or greater than 10 nm and equal to or less than 500 nm.

4. The producing process for an ink for printing processes according to any one of claims 1 to 3, comprising a step to set up the volume average particle size of the metal nanoparticles to be equal to or greater than 2 nm and equal to or less than 500 nm.

5. The producing process for an ink for printing processes according to any one of claims 1 to 4, comprising the step of dispersing the metal nanoparticles containing Cu and/or CuO and/or $Cu_2O$ in a dispersion medium having a vapor pressure at 25°C of less than $1.34 \times 10^3$ Pa, and the viscosity at 25°C is set up to be 50 mPa·s or less.

6. The producing process for an ink for printing processes according to claim 5, the dispersion medium being an organic polar solvent in which the polar term in the Hansen solubility parameter is 11 $MPa^{0.5}$ or greater.

7. The producing process for an ink for printing processes according to claim 1, comprising a step of providing metal nanoparticles having a volume average particle size of the primary particles of D (nm) and a dispersion medium, wherein when the average interparticle distance between adjacent metal nanoparticles in the ink for printing processes is designated as L (nm), the relation: $1.6 \leq L/D \leq 3.5$ is satisfied, and the dispersion medium being such that the polar term in the Hansen solubility parameter is 11 $MPa^{0.5}$ or greater.

8. The producing process for an ink for printing processes according to claim 7, comprising a step to set up the volume average particle size (D) of the primary particles of the metal nanoparticles to be 10 to 300 nm.

9. The producing process for an ink for printing processes according to claim 7 or 8, comprising the step of forming the metal nanoparticles from one kind, or a mixture of two or more kinds, of at least one or more element selected from Cu, Ag, Au, Al, Ni, Co, Pd, Sn, Pb, In and Ga, and/or partial or total oxides thereof.

10. The producing process for an ink for printing processes according to any one of claims 7 to 9, comprising the step of preparing the ink without using a dispersant for the metal nanoparticles.

11. The producing process for an ink for printing processes according to any one of claims 7 to 10, wherein the viscosity at 25°C is set up to be 0.1 to 50 Pa·s.

12. The producing process for an ink for printing processes according to any one of claims 1 to 11, wherein the printing process is plateless printing process.

**Patentansprüche**

1. Herstellungsverfahren für eine Tinte für Druckverfahren, umfassend einen Schritt der Verwendung von wenigstens Metallnanopartikeln und des Einstellens des Kohlenstoffatomgehalts in dem Gesamtfeststoffgehalt auf 0,4 Masse-% oder weniger, wobei die Metallnanopartikel Cu und/oder CuO und/oder $Cu_2O$ enthalten, und außerdem umfassend einen Schritt des Einstellens der Menge an ionischen Verunreinigungen auf 2.600 ppm oder weniger im Gesamtfeststoffgehalt, außerdem umfassend einen Schritt des Einstellens des absoluten Wertes des Zeta-Potentials auf 30 mV oder höher.

2. Herstellungsverfahren für eine Tinte für Druckverfahren gemäß Anspruch 1, wobei die Menge an ionischen Verunreinigungen auf 1.600 ppm oder weniger in einem trockenen Pulver der Metallnanopartikel eingestellt wird und die Tinte in einem Schritt des Dispergierens von Metallnanopartikeln, die Cu und/oder CuO und/oder $Cu_2O$ enthalten, in einem Dispersionsmedium hergestellt wird.

3. Herstellungsverfahren für eine Tinte für Druckverfahren gemäß einem der Ansprüche 1 oder 2, umfassend einen Schritt des Einstellens der 90%-Dispersionspartikelgröße der Metallnanopartikel, die Cu und/oder CuO und/oder $Cu_2O$ enthalten, auf gleich oder größer als 10 nm und gleich oder kleiner als 500 nm.

4. Herstellungsverfahren für eine Tinte für Druckverfahren gemäß einem der Ansprüche 1 bis 3, umfassend einen Schritt des Einstellens der volumendurchschnittlichen Partikelgröße der Metallnanopartikel auf gleich oder größer als 2 nm und gleich oder kleiner als 500 nm.

5. Herstellungsverfahren für eine Tinte für Druckverfahren gemäß einem der Ansprüche 1 bis 4, umfassend den Schritt des Dispergierens der Metallnanopartikel, die Cu und/oder CuO und/oder $Cu_2O$ enthalten, in einem Dispersions-medium, das bei 25°C einen Dampfdruck von weniger als $1,34 \times 10^3$ Pa hat, und wobei die Viskosität bei 25°C auf 50 mPa·s oder weniger eingestellt wird.

6. Herstellungsverfahren für eine Tinte für Druckverfahren gemäß Anspruch 5, wobei das Dispersionsmedium ein organisches polares Lösungsmittel ist, in dem der polare Term im Hansen-Löslichkeitsparameter 11 $MPa^{0,5}$ oder größer ist.

7. Herstellungsverfahren für eine Tinte für Druckverfahren gemäß Anspruch 1, umfassend einen Schritt des Bereitstellens von Metallnanopartikeln mit einer volumendurchschnittlichen Partikelgröße der Primärpartikel D (nm) und eines Dispersionsmediums, wobei der durchschnittliche Zwischenpartikelabstand zwischen benachbarten Metallnanopartikeln in der Tinte für Druckverfahren als L (nm) bezeichnet wird, die Beziehung: $1,6 \leq L/D \leq 3,5$ erfüllt wird und das Dispersionsmedium so ist, dass der polare Term im Hansen-Löslichkeitsparameter 11 $MPa^{0,5}$ oder größer ist.

8. Herstellungsverfahren für eine Tinte für Druckverfahren gemäß Anspruch 7, umfassend einen Schritt des Einstellens der volumendurchschnittlichen Partikelgröße (D) der Primärpartikel der Metallnanopartikel auf 10 bis 300 nm.

9. Herstellungsverfahren für eine Tinte für Druckverfahren gemäß Anspruch 7 oder 8, umfassend den Schritt des Bildens der Metallnanopartikel aus einer Art oder einem Gemisch aus zwei oder mehr Arten von wenigstens einem oder mehreren Element(en), ausgewählt aus Cu, Ag, Au, Al, Ni, Co, Pd, Sn, Pb, In und Ga, und/oder Partial- oder Gesamtoxiden davon.

10. Herstellungsverfahren für eine Tinte für Druckverfahren gemäß einem der Ansprüche 7 bis 9, umfassend den Schritt des Herstellens der Tinte ohne Verwendung eines Dispergiermittels für die Metallnanopartikel.

11. Herstellungsverfahren für eine Tinte für Druckverfahren gemäß einem der Ansprüche 7 bis 10, wobei die Viskosität bei 25°C auf 0,1 bis 50 mPa·s eingestellt wird.

12. Herstellungsverfahren für eine Tinte für Druckverfahren gemäß einem der Ansprüche 1 bis 11, wobei das Druckverfahren ein plattenloses Druckverfahren ist.

**Revendications**

1. Procédé de production d'une encre pour des procédés d'impression, comprenant une étape d'utilisation au moins de nanoparticules métalliques, et de fixation d'une teneur en atome de carbone dans la teneur totale en matières sèches de 0,4 % en masse ou moins, les nanoparticules métalliques contenant Cu et/ou CuO et/ou $Cu_2O$, et comprenant en outre une étape de fixation de la quantité d'impuretés ioniques à 2 600 ppm ou moins dans la teneur totale en matières sèches, comprenant en outre une étape de fixation de la valeur absolue du potentiel zêta à 30 mV ou plus.

2. Procédé de production d'une encre pour des procédés d'impression selon la revendication 1, dans lequel la quantité d'impuretés ioniques est fixée à 1 600 ppm ou moins dans une poudre sèche des nanoparticules métalliques, et l'encre est préparée dans une étape de dispersion de nanoparticules métalliques contenant Cu et/ou CuO et/ou $Cu_2O$ dans un milieu de dispersion.

3. Procédé de production d'une encre pour des procédés d'impression selon l'une quelconque de la revendication 1 ou 2, comprenant une étape de fixation de la taille de particules de dispersion à 90 % des nanoparticules métalliques contenant Cu et/ou CuO et/ou $Cu_2O$ pour qu'elle soit supérieure ou égale à 10 nm ou inférieure ou égale à 500 nm.

4. Procédé de production d'une encre pour des procédés d'impression selon l'une quelconque des revendications 1 à 3, comprenant une étape de fixation de la taille moyenne de particules en volume des nanoparticules métalliques pour qu'elle soit supérieure ou égale à 2 nm et inférieure ou égale à 500 nm.

5. Procédé de production d'une encre pour des procédés d'impression selon l'une quelconque des revendications 1 à 4, comprenant l'étape de dispersion des nanoparticules métalliques contenant Cu et/ou CuO et/ou $Cu_2O$ dans un milieu de dispersion ayant une pression de vapeur à 25 °C de moins de 1,34 x $10^3$ Pa, et la viscosité à 25 °C est fixée à 50 mPa·s ou moins.

6. Procédé de production d'une encre pour des procédés d'impression selon la revendication 5, le milieu de dispersion étant un solvant polaire organique dans lequel le terme polaire dans le paramètre de solubilité de Hansen est de 11 $MPa^{0,5}$ ou plus.

7. Procédé de production d'une encre pour des procédés d'impression selon la revendication 1, comprenant une étape de fourniture de nanoparticules métalliques ayant une taille moyenne de particules en volume des particules primaires de D (nm) et un milieu de dispersion, dans lequel lorsque la distance interparticules moyenne entre des nanoparticules métalliques adjacentes dans l'encre pour des procédés d'impression est désignée par L (nm), la relation : $1,6 \leq L/D \leq 3,5$ est satisfaite, et le milieu de dispersion étant tel que le terme polaire dans le paramètre de solubilité de Hansen est de 11 $MPa^{0,5}$ ou plus.

8. Procédé de production d'une encre pour des procédés d'impression selon la revendication 7, comprenant une étape de fixation de la taille moyenne de particules en volume (D) des particules primaires des nanoparticules métalliques pour qu'elle soit de 10 à 300 nm.

9. Procédé de production d'une encre pour des procédés d'impression selon la revendication 7 ou 8, comprenant l'étape de formation des nanoparticules métalliques à partir d'une sorte, ou d'un mélange de deux sortes ou plus, d'au moins un élément ou plus choisi parmi Cu, Ag, Au, Al, Ni, Co, Pd, Sn, Pb, In et Ga, et/ou d'oxydes partiels ou totaux de ceux-ci.

10. Procédé de production d'une encre pour des procédés d'impression selon l'une quelconque des revendications 7 à 9, comprenant l'étape de préparation de l'encre sans utiliser de dispersant pour les nanoparticules métalliques.

11. Procédé de production d'une encre pour des procédés d'impression selon l'une quelconque des revendications 7 à 10, dans lequel la viscosité à 25 °C est fixée à 0,1 à 50 mPa·s.

12. Procédé de production d'une encre pour des procédés d'impression selon l'une quelconque des revendications 1 à 11, dans lequel le procédé d'impression est un procédé d'impression sans plaque.

# FIG. 1

→| |← → 110 μ m

# FIG. 2

## FIG. 3

## FIG. 4

## FIG. 5

| BEFORE TREATMENT | AFTER TREATMENT |

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 20100233011 A1
- US 20120125659 A1
- JP 2561537 B
- JP 2003334618 A
- JP 2003311944 A
- JP 3764349 B
- WO 2005025787 A
- JP 2004211108 A
- JP 2008127679 A
- JP 2008088518 A
- WO 2006019144 A
- JP 2008138286 A
- JP 3953237 B
- JP 2004315853 A
- JP 2009215501 A
- JP 2004119686 A
- JP 2007083288 A

**Non-patent literature cited in the description**

- INDUSTRIAL SOLVENTS HANDBOOK. Marcel Dekker, Inc, 1996, 35-68
- HANSEN SOLUBILITY PARAMETERS: A USER'S HANDBOOK. CRC Press, 1999, 1-41
- DIRECTORY OF SOLVENTS. Blackie Academic & Professional, 1996, 22-29